# EUROPEAN PATENT APPLICATION

(11) **EP 2 613 361 A1**
(43) Date of publication of application: **10.07.2013**
(21) Application number: 11821482.4
(22) Date of filing: 28.07.2011
(51) Int. Cl.: H01L 31/042, B32B 27/32, C08L 23/04, C09K 3/10

(54) **SOLAR CELL SEALING MATERIAL AND SOLAR CELL MODULE PRODUCED BY USING SAME**

(30) Priority: 18.01.2011 JP 2011008102; 30.08.2010 JP 2010192643
(71) Applicant: MITSUBISHI PLASTICS, INC., Chiyoda-ku, Tokyo 100-8252 (JP)
(72) Inventor: OTSUKA, Michiko, Nagahama-shi Shiga 526-8660 (JP); NISHIOKA, Jun, Nagahama-shi Shiga 526-8660 (JP); TANIGUCHI, Kouichirou, Nagahama-shi Shiga 526-8660 (JP)
(74) Representative: HOFFMANN EITLE
(86) International application number: PCT/JP2011/067227
(87) International publication number: WO 2012/029464

(57) **Abstract**

Provided are a solar cell encapsulant material which facilitates production of solar cell modules and which is excellent in all of adhesiveness, long-term stability of adhesion power, transparency and heat resistance, and a solar cell module produced by using the encapsulant material. The solar cell encapsulant material has at least an adhesive layer (layer (I)) and a layer (layer (II)) of a resin composition (C) that contains an ethylene-α-olefin random copolymer (A) satisfying the following requirement (a) and an ethylene-α-olefin block copolymer (B) satisfying the following requirement (b): (a) The heat of crystal fusion of the copolymer, as measured at a heating rate of 10°C/min in differential scanning calorimetry, is from 0 to 70 J/g; (b) As measured at a heating rate of 10°C/min in differential scanning calorimetry, the crystal melting peak temperature of the copolymer is 100°C or higher, and the heat of crystal fusion thereof is from 5 to 70 J/g.

## Description

### TECHNICAL FIELD

The present invention relates to an encapsulant material for solar cell elements in solar cell modules, and to a solar cell module produced by using the encapsulant material, and more precisely relates to a solar cell encapsulant material which facilitates production of solar cell modules and which is excellent in adhesiveness, long-term stability of adhesion power, transparency, heat resistance and others, and to a solar cell module produced by using the encapsulant material.

### BACKGROUND ART

A solar cell is a power-generating unit that directly converts the light energy of sunlight to electricity. Solar power generation does not require firing of fuel such as oil or the like and has a property that it does not generate greenhouse gas (e.g., CO₂, etc.) and any harmful waste (e.g., crude oil ash and heavy oil ash) by firing, and therefore has become specifically noted as one type of clean energy these days. A solar battery comprises a large number of solar cell elements (simply referred to as cells) that are wired in series or in parallel, and as placed outdoors, the solar battery is so configured that the constitutive solar cell elements are sealed in resin and the outside thereof is protected with glass or sheet, in order that it could evade influences of water and dust thereon, could be protected from collision with hailstones, stones and the like and could be resistant to wind pressure; and the configuration of the type is referred to as a solar cell module. One concrete embodiment of the solar cell module comprises, as protective parts, a transparent substrate of a top protective material to protect the face of the module to be exposed to sunlight (glass/translucent solar cell sheet; front sheet) and a back sealing sheet of a back protective material to protect the back thereof (back sheet, for example, polyvinyl fluoride resin film), and an encapsulant material (encapsulant resin layer) of a thermoplastic resin (for example, ethylene-vinyl acetate copolymer) to fill up the space between the former two.
As described above, those solar cell modules are mainly used outdoors for a long period of time, and are therefore required to satisfy various properties in point of the configuration, the material constitution and others thereof. Of the above-mentioned protective parts, the encapsulant material (encapsulant resin layer) is specifically referred to. The encapsulant material is essentially required to have water vapor barrier performance, softness for protecting solar cell elements and processability in producing solar cell modules, concretely, flowability to fill up the space between cells and wirings, impact resistance, heat resistance for protecting solar cell modules in heat generation, transparency (total light transmission, etc.) for efficient arrival of sunlight to solar cell elements, adhesiveness to glass, back sheet and cells, durability, dimensional stability, insulating performance, etc.

At present, as an encapsulant material for solar cell elements in solar cell modules, an ethylene-vinyl acetate copolymer (hereinafter this may be abbreviated as EVA) is widely used as the constituent material thereof (for example, see PTL 1). Mainly for imparting heat resistance to EVA, crosslinking is attained with an organic peroxide serving as a crosslinking agent. For this, there is employed a method of previously preparing an EVA sheet mixed with a crosslinking agent (organic peroxide) and a crosslinking promoter and sealing up solar cell elements by the use of the resulting sheet.
However, in case where solar cell modules are produced by the use of the EVA sheet, EVA may thermal decompose to generate acetic acid gas thereby having some negative influences on the working environment and the production apparatus and bringing about some problems of circuit corrosion in solar cells, interlayer delamination of various parts such as solar cell elements, front sheet, back sheet and others, depending on various conditions in their production such as thermal bonding under pressure, etc.

Against these problems, for example, PTL 2 discloses a solar cell encapsulant material comprising a resin composition that contains an amorphous α-olefin polymer and a crystalline α-olefin polymer, as a solar cell encapsulant material not using an EVA sheet and requiring a crosslinking process, in which concretely used is a resin composition comprising a polymer with propylene as the main ingredient thereof.
PTL 3 discloses a solar cell encapsulant material of a polymer blend or a polymer alloy that comprises at least one polyolefine-based copolymer and at least one crystalline polyolefin, in which concretely used are a polymer blend of an ethylene-methacrylic acid copolymer and an ordinary crystalline polyethylene (see Example 2), and a polymer blend of an ethylene-methyl acrylate copolymer and an ordinary crystalline polypropylene (see Example 3).
PTL 4 discloses a solar cell encapsulant material comprising a silane-modified resin (silane-crosslinking resin) prepared through polymerization of an ethylene-based unsaturated silane compound and a polymerizing polyethylene.

### CITATION LIST

### PATENT LITERATURE

PTL1: JP-A 58-60579
PTL2: JP-A 2006-210905
PTL3: JP-A 2001-332750
PTL4: JP-A 2005-19975

### SUMMARY

### TECHNICAL PROBLEM

However, the resin composition formed of a polymer that comprises propylene as the main ingredient thereof, as in PTL2, is still insufficient in transparency (total light transmission: 83.2% (see Examples)). In addition, the polymer that comprises propylene as the main ingredient thereof has another problem in that its brittle temperature is high and its low-temperature properties are poor. Examples of the polymer blend used in PTL3 are not always satisfactory in point of transparency, and are therefore still problematic in the balance among softness, heat resistance and transparency.
Regarding the filler layer in the solar cell module of PTL4, when a large amount of the silane-modified resin is added to the layer in order to sufficiently express the adhesiveness to the adherends such as glass, back sheet and others, the haze may increase and the transparency may lower, or that is, there still remains a problem in point of the balance between adhesiveness and transparency.
A method of adding a silane coupling agent for imparting adhesiveness to ordinary sealing materials is known, which, however, is problematic in that the silane coupling agent may bleed out with time and may react with water to lower the adhesion force thereof, and there is a room for improvement of the technique.

As described above, in conventional technology, no one could succeed in providing a solar cell sealing material which facilitates production of solar cell modules and which is excellent in all of adhesiveness, long-term stability of adhesion power, transparency, heat resistance and others, and in providing a solar cell module produced by using the encapsulant material.
An object of the present invention is to provide a solar cell encapsulant material which facilitates production of solar cell modules and which is excellent in all of adhesiveness, long-term stability of adhesion power, transparency and heat resistance, and to provide a solar cell module produced by using the encapsulant material.

### SOLUTION TO PROBLEM

As a result of assiduous studies, the present inventors have found that a solar cell encapsulant material having an adhesive layer and a layer of a resin composition that contains an ethylene-α-olefin random copolymer having specific thermal properties and an ethylene-α-olefin block copolymer having specific thermal properties can satisfy all of adhesiveness, long-term stability of adhesion power, transparency and heat resistance, and have completed the present invention. Specifically, the present invention relates to a solar cell sealing material having at least an adhesive layer, especially a layer (layer (I)) of a specific resin composition (Z) that contains a polyethylene-based resin (X) and a silane-modified ethylene-based resin (Y), and a layer (layer (II)) of a resin composition (C) that contains an ethylene-α-olefin random copolymer (A) satisfying the following requirement (a) and an ethylene-α-olefin block copolymer (B) satisfying the following requirement (b):
(a) The heat of crystal fusion of the copolymer, as measured at a heating rate of 10°C/min in differential scanning calorimetry, is from 0 to 70 J/g;
(b) As measured at a heating rate of 10°C/min in differential scanning calorimetry, the crystal melting peak temperature of the copolymer is 100°C or higher, and the heat of crystal fusion thereof is from 5 to 70 J/g.

### Advantageous Effects of Invention

According to the present invention, there are provided a solar cell encapsulant material which facilitates production of solar cell modules and which is excellent in all of adhesiveness, long-term stability of adhesion power, transparency and heat resistance, and a solar cell module produced by using the encapsulant material.
In addition, the present invention is free from problems of degradation of solar cell elements owing to wiring corrosion by acetic acid or owing to water vapor transmission thereinto, and can prevent negative influences on the working environment and the production apparatus and can prevent degradation of solar cell modules and power generation efficiency reduction therein. Further, regarding the production equipment, the present invention is applicable to not only batch-type production lines but also to roll-to-roll system production lines. In addition, in regeneration and addition, the present invention can prevent reduction in transparency.

### BRIEF DWSCRIPTION OF THE DRAWING

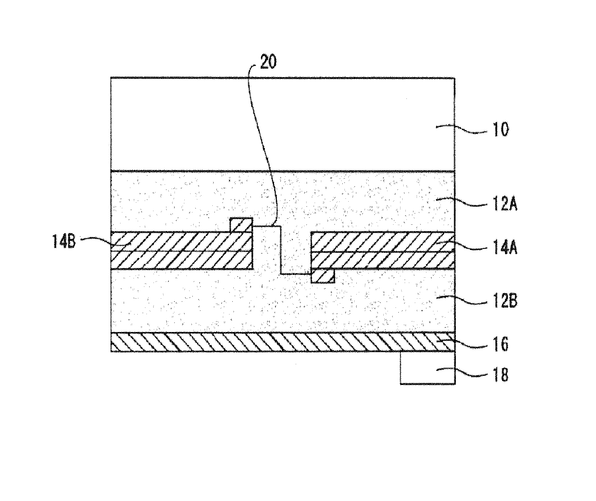

[Fig. 1] This is a schematic cross-sectional view showing one example of the solar cell module of the present invention.

### DESCRIPTON OF EMBODIMENTS

As embodiments of the present invention, the solar cell encapsulant material and the solar cell module produced by the use of the encapsulant material are described below.
In the present specification, the "main ingredient" is stated to the effect that the composition may contain any other ingredient within a range not detracting from the effect and the advantage of the resin that constitutes the individual layers of the solar cell material of the present invention. Further, though the term thereof is not to restrict any concrete content, the main ingredient is an ingredient that accounts for generally 50 parts by mass or more relative to 100 parts by mass of all the constituent ingredients of the resin composition, preferably 65 parts by mass or more, more preferably 80 parts by mass or more, and is 100 parts by mass or less.

### <Layer (I)>

Of the layers constituting the solar cell encapsulant material of the present invention, the layer (I) is an adhesive layer, or that is, a layer playing a role of not only a sealing layer but also an adhesive layer and a surface layer in the solar cell encapsulant material of the present invention. Not specifically defined, the resin composition for the layer (I) is preferably one that comprises a polyethylene-based resin as the main ingredient thereof, from the viewpoint of the adhesiveness, the long-term stability of adhesion power, the transparency and the heat resistance thereof and also from the viewpoint of the productivity in forming the film of the solar cell encapsulant material.

### [Polyolefin-based Resin]

Not specifically defined, the Polyolefin-based resin for the layer (I) is preferably at least one modified polyolefin-based resin selected from a group consisting of ethylene-methyl methacrylate copolymer (E-MMA), ethylene-ethyl acrylate copolymer (E-EAA), ethylene-glycidyl methacrylate copolymer (E-GMA), ethylene-vinyl alcohol copolymer (EVOH), ionomer resin (ion-crosslinked ethylene-methacrylic acid copolymer, ion-crosslinked ethylene-acrylic acid copolymer), silane-modified polyolefin (silane-crosslinked polyolefin), and maleic anhydride graft copolymer, from the viewpoint of the adhesiveness, the transparency, the productivity and the industrial availability thereof.

For the layer (I) in the present invention, preferred is a silane-crosslinked polyolefin or an ionomer resin from the viewpoint of the adhesiveness and the heat resistance thereof. Of the silane-crosslinked polyolefin, more preferred is a silane-crosslinked polyethylene. Above all, even more preferred is a silane-crosslinked linear low-density polyethylene (density; 0.850 to 0.920 g/cm³), as further bettering the transparency of the layer.

Not specifically defined, the content of the monomer that modifies the modified polyolefin-based resin is generally 0.5 mol% or more relative to all the monomers constituting the modified polyolefin-based resin, but preferably 1 mol% or more, even more preferably 2 mol% or more, and is generally 40 mol% or less, preferably 30 mol% or less, even more preferably 25 mol% or less. The range is preferred because, within the range, the copolymerization component reduces the crystallinity of the polymer and therefore enhances the transparency thereof, and in addition, the raw material pellets hardly block together. The type and the content of the monomer to modify to give the modified polyolefin-based polymer may be determined through qualitative and quantitative analysis according to a known method, for example, using a nuclear magnetic resonance (NMR) apparatus or any other analyzer.

The production method the modified polyolefin-based resin is not specifically defined, for which is employable any known polymerization method using a known olefin polymerization catalyst, except for the following ionomer resin, silane-crosslinked polyolefin and maleic acid-graft copolymer. For example, there are mentioned a slurry polymerization method, a solution polymerization method, a bulk polymerization method, a vapor-phase polymerization method or the like using a multi-site catalyst such as typically a Ziegler-Natta catalyst, or a single-site catalyst such as typically a metallocene catalyst, and a bulk polymerization method using a radical initiator, etc.

The ionomer resin may be produced by neutralizing at least a part of the unsaturated carboxylic acid moiety of a copolymer comprising ethylene, an unsaturated carboxylic acid and optionally any other unsaturated compound, with at least any one of a metal ion or an organic amine. The ionomer resin may also be produced by saponifying at least a part of the unsaturated carboxylate moiety of a copolymer comprising ethylene, an unsaturated carboxylate and optionally any other unsaturated compound.

The silane-crosslinked polyolefin may be produced by melting and mixing a polyolefin-based resin, a silane coupling agent to be mentioned below and a radical generator to be mentioned below at a high temperature, and graft-polymerizing them.
The maleic anhydride graft copolymer may be produced by melting and mixing a polyolefin-based resin, maleic anhydride and a radical generator to be mentioned below at a high temperature, and graft-polymerizing them.

Specific examples of the modified polyolefin-based resin include Sumitomo Chemical's trade name "ACRYFT" for E-MMA (ethylene-methyl methacrylate copolymer); Japan Polyethylene's trade name "REXPEARL EEA" for E-EAA (ethylene-ethyl acrylate copolymer); Sumitomo Chemical's trade name "BONDFAST" for E-GMA (ethylene-glycidyl methacrylate copolymer); Japan Gohsei's trade name "SOANOL" and Kuraray's "EVAL" as EVOH (ethylene-vinyl alcohol copolymer); Mitsui DuPont Polychemical's trade name "HIMILAN" as ionomer resin; Mitsubishi Chemical's trade name "LINKLON" as silane-crosslinked polyolefin; and Mitsui Chemical's "ADMER" as maleic anhydride graft copolymer.

Not specifically defined, the melt flow rate (MFR) of the polyolefin-based resin for use in the layer (I) is generally from 0.5 to 100 g/10 min as MFR (JIS K7210, temperature: 190°C, load: 21.18 N), but preferably from 2 to 50 g/10 min, more preferably from 3 to 30 g/10 min. In this, MFR may be selected in consideration of the moldability and the workability in molding into sheets, the adhesiveness and the spreadability in encapsulant solar cell elements (simply referred to as cells), etc. For example, when sheets are produced through calender-molding, MFR of the resin to be used is preferably a relatively low value, concretely from 0.5 to 5 g/10 min or so in view of the handleability in peeling the sheet from molding rolls; but when sheets are produced through extrusion using a T-die, MFR of the resin is preferably from 2 to 50 g/10 min, more preferably from 3 to 30 g/10 min from the viewpoint of reducing the extrusion load and increasing the extrusion output. Further, from the viewpoint of the adhesiveness and the spreadability in sealing solar cell elements (simply referred to as cells), MFR of the resin to be used is preferably from 2 to 50 g/10 min, more preferably from 3 to 30 g/10 min.

In the present invention, for obtaining the solar cell encapsulant material which facilitates production of solar cell modules and which is excellent in transparency and simultaneously also in adhesiveness and heat resistance, preferably used is a layer of a resin composition (Z) that contains a polyethylene-based resin (X) and a silane-modified ethylene-based resin (Y), as the above-mentioned adhesive layer (layer (I)). In this case, the resin composition (Z) must satisfy the requirement (a) that the heat of crystal fusion thereof, as measured at a heating rate of 10°C/min in differential scanning calorimetry, is from 0 to 70 J/g.

### [Polyethylene-based Resin (X)]

The polyethylene-based resin (X) for use in the present invention is not specifically defined so far as it does not interfere with the resin composition (Z) satisfying the above-mentioned requirement (a). Concretely, the resin includes low-density polyethylene, ultralow-density polyethylene or linear low-density polyethylene. More concretely, preferred is a polyethylene-based resin having a density of from 0.850 to 0.920 g/cm³, and more preferred is a linear low-density polyethylene having a density of from 0.860 to 0.880 g/cm³. Polyethylene-based resins each having a different density may be combined for use herein.

The polyethylene-based resin having a low density and preferred for use in the present invention is generally a random copolymer of ethylene and an α-olefin having from 3 to 20 carbon atoms. In this, the α-olefin to copolymerize with ethylene includes propylene, 1-butene, 1-pentene, 1-hexene, 1-heptene, 1-octene, 1-nonene, 1-decene, 3-methyl-butene-1, 4-methyl-pentene-1, etc. In the present invention, propylene, 1-butene, 1-hexene and 1-octene are preferably used as the α-olefin to copolymerize with ethylene, from the viewpoint of the industrial availability, various special properties and the economic potential thereof. One alone or two or more different types of α-olefins to copolymerize with ethylene may be used here either singly or as combined.

The content of the α-olefin to copolymerize with ethylene is 2 mol% or more relative to the total monomer units in the ethylene-α-olefin random copolymer, and preferably 40 mol% or less, more preferably from 3 to 30 mol%, even more preferably from 5 to 25 mol%. Falling within the range, the comonomer α-olefin may reduce the crystallinity of the copolymer and may therefore enhance the transparency thereof; and another advantage thereof is that the raw material pellets hardly block together. The type and the content of the α-olefin to copolymerize with ethylene may be determined through qualitative and quantitative analysis according to a known method, for example, using a nuclear magnetic resonance (NMR) apparatus or any other analyzer.

The ethylene-α-olefin random copolymer may contain any other monomer unit derived from other monomers than α-olefins. The additional monomer includes, for example, cyclic olefins, vinyl-aromatic compounds (styrene, etc.), polyene compounds, etc. The content of the additional monomer unit is preferably 20 mol% or less based on all the monomer units, 100 mol% in the ethylene-α-olefin random copolymer, more preferably 15 mol% or less. The configuration, the branched structure, the branching degree distribution and the molecular weight distribution of the ethylene-α-olefin random copolymer are not specifically defined. For example, a copolymer having long-chain branches could generally have good mechanical properties and have advantages in that its melt tension in molding into sheets is high and the calendering moldability thereof is good. A copolymer having a narrow molecular weight distribution, as produced through polymerization with a single-site catalyst, contains few low-molecular-weight components, and another advantage thereof is that the raw material pellets hardly block together.

Not specifically defined, the melt flow rate (MFR) of the polyethylene-based resin (X) for use in the present invention is generally from 0.1 to 100 g/10 min or so as MFR thereof (JIS K7210, temperature: 190°C, load: 21.18 N), preferably from 2 to 50 g/10 min, more preferably from 3 to 30 g/10 min. In this, MFR may be selected in consideration of the moldability and the workability in molding into sheets, the adhesiveness and the spreadability in sealing solar cell elements (simply referred to as cells), etc. For example, when sheets are produced through calender-molding, MFR of the resin to be used is preferably a relatively low value, concretely from 0.5 to 5 g/10 min or so in view of the handleability in peeling the sheet from molding rolls; but when sheets are produced through extrusion using a T-die, MFR of the resin is preferably from 2 to 50 g/10 min, more preferably from 3 to 30 g/10 min from the viewpoint of reducing the extrusion load and increasing the extrusion output. Further, from the viewpoint of the adhesiveness and the spreadability in sealing solar cell elements (simply referred to as cells), MFR of the resin to be used is preferably from 2 to 50 g/10 min, more preferably from 3 to 30 g/10 min.

In order that the resin composition (Z) can satisfy the above-mentioned requirement (a), the heat of crystal fusion of the polyethylene-based resin (X) for use in the present invention, as measured at a heating rate of 10°C/min in differential scanning calorimetry, preferably falls from 0 to 70 J/g, more preferably from 5 to 70 J/g, even more preferably from 10 to 65 J/g. Falling within the range, the resin is preferred as capable of securing the softness and the transparency (total light transmission) of the solar cell encapsulant material of the present invention. When the heat of crystal fusion is 5 J/g or higher, it is favorable since the raw material pellets hardly block together.
The heat of crystal fusion may be measured at a heating rate of 10°C/min, using a differential scanning calorimeter and according to JIS K7122.

The mean refractive index of the polyethylene-based resin (X) for use in the present invention is generally within a range of from 1.4800 to 1.5000, but is preferably from 1.4810 to 1.4990, more preferably from 1.4820 to 1.4980. When the compositional ratio of the polyethylene-based resin (X) is defined to fall within the above-mentioned range, then the mean refractive index of the resin may be made to fall within the preferred range.
The mean refractive index may be measured according to JIS K7142 at a temperature of 23°C and using a sodium D ray (589 nm) as the light source.
One alone or two or more different types of the above-mentioned polyethylene-based resins (X) may be used here either singly or as combined.

The production method for the polyethylene-based resin (X) for use in the present invention is not specifically defined, for which is employable any known polymerization method using a known olefin polymerization catalyst. For example, there are mentioned a slurry polymerization method, a solution polymerization method, a bulk polymerization method, a vapor-phase polymerization method or the like using a multi-site catalyst such as typically a Ziegler-Natta catalyst, or a single-site catalyst such as typically a metallocene catalyst or a post-metallocene catalyst, and a bulk polymerization method using a radical initiator, etc. In the present invention, since the ethylene-α-olefin random copolymer having a low density and preferred for use herein is a relatively soft resin and from the viewpoint of attaining easy granulation (pelletization) after polymerization and also from the viewpoint of preventing the raw material pellets from blocking together, preferred is a polymerization method using a single-site catalyst, in which a raw material can be polymerized to give a polymer having few low-molecular-weight components and having a narrow molecular weight distribution.

Specific examples of polyethylene-based resin (X) for use in the present invention include Dow Chemical's trade names "ENGAGE", "AFFINITY" and "INFUSE", Mitsui Chemical's trade names "TAFMER A" and TAFMER P", Japan Polyethylene's trade name "KARNEL", etc.

### [Silane-Modified Ethylene-based Resin (Y)]

The silane-modified ethylene-based resin (Y) for use in the present invention is generally obtained by melting and mixing a polyethylene-based resin, a vinylsilane compound to be mentioned below and a radical generator to be mentioned below, at a high temperature (160°C to 220°C or so), and graft-polymerizing them.

### (Polyethylene-based Resin)

The polyethylene-based resin to be used for obtaining the above-mentioned (Y) preferably has the same composition and density, MFR, heat of crystal fusion and mean refractive index as those of the polyethylene-based resin that has been mentioned hereinabove as one preferred for the above-mentioned (X).
Concretely, preferred is a polyethylene-based resin having a density of from 0.850 to 0.920 g/cm³, and more preferred is a linear low-density polyethylene having a density of from 0.860 to 0.880 g/cm³. Not specifically defined, the melt flow rate (MFR) of the resin is generally from 0.5 to 100 g/10 min or so as MFR thereof (JIS K7210, temperature; 190°C, load: 21.18 N), but is preferably from 2 to 50 g/10 min, more preferably from 3 to 30 g/10 min.
Also preferably, the heat of crystal fusion of the resin, as measured at a heating rate of 10°C/min in differential scanning calorimetry, preferably falls from 0 to 70 J/g, more preferably from 5 to 70 J/g, even more preferably from 10 to 65 J/g. The mean refractive index of the resin is generally within a range of from 1.4800 to 1.5000, but above all, preferably from 1.4810 to 1.4990, more preferably from 1.4820 to 1.4980.

In case where the polyethylene-based resin is an ethylene-α-olefin random copolymer, the content of the α-olefin to copolymerize with ethylene is generally 2 mol% or more relative to the total monomer units in the ethylene-α-olefin random copolymer, and preferably 40 mol% or less, more preferably from 3 to 30 mol%, even more preferably from 5 to 25 mol%. Falling within the range, the comonomer α-olefin may reduce the crystallinity of the copolymer and may therefore enhance the transparency thereof; and another advantage thereof is that raw material pellets hardly block together.

### (Vinylsilane Compound)

Not specifically defined, the vinylsilane compound may be any one capable of graft-copolymerizing with the above-mentioned polyethylene-based resin. For example, herein usable is at least one selected from a group consisting of vinyltrimethoxysilane, vinyltriethoxysilane, vinyltripropoxysilane, vinyltriisopropoxysilane, vinyltributoxysilane, vinyltripentyloxysilane, vinyltriphenoxysilane, vinyltribenzyloxysilane, vinyltrimethylenedioxysilane, vinyltriethylenedioxysilane, vinylpropionyloxysilane, vinyltriacetoxysilane, and vinyltricarboxysilane. In the present invention, preferred is use of vinyltrimethoxysilane from the viewpoint of the reactivity, the adhesiveness and the color of the composition.

Not specifically defined, the amount of the vinylsilane compound to be added is generally from 0.01 to 10.0 parts by mass relative to 100 parts by mass of the polyethlene-based resin to be sued, more preferably from 0.3 to 8.0 parts by mass, even more preferably from 1.0 to 5.0 parts by mass.

### (Radical Generator)

Not specifically defined, the radical generator includes, organic peroxides, for example, hydroperoxides such as diisopropylbenzene hydroperoxide, 2,5-dimethyl-2,5-di(hydroperoxy)hexane, etc.; dialkyl peroxides such as di-t-butyl peroxide, di-t-butylcumyl peroxide, dicumyl peroxide, 2,5-dimethyl-2,5-di(t-butylperoxy)hexane, 2,5-dimethyl-2,5-di(t-peroxy)hexyne-3, etc.; diacyl peroxides such as bis-3,5,5-trimethylhexanoyl peroxide, octanoyl peroxide, benzoyl peroxide, o-methylbenzoyl peroxide, 2,4-dichlorobenzoyl peroxide, etc.; peroxyesters such as t-butylperoxy acetate, t-butylperoxy-2-ethyl hexanoate, t-butylperoxy pivalate, t-butylperoxy octanoate, t-butylperoxyisopropyl carbonate, t-butylperoxy benzoate, di-t-butylperoxy phthalate, 2,5-dimethyl-2,5-di(benzoylperoxy)hexane, 2,5-dimethyl-2,5-di(benzoylperoxy)hexyne-3, etc.; ketone peroxides such as methyl ethyl ketone peroxide, cyclohexanone peroxide, etc.; azo compounds such as azobisisobutyronitrile, azobis(2,4-dimethylvaleronitrile), etc.

Not specifically defined, the amount of the radical generator to be added is generally from 0.01 to 5.0 parts by mass relative to 100 parts by mass of the polyethylene-based resin to be used, more preferably from 0.02 to 1.0 part by mass, even more preferably from 0.03 to 0.5 parts by mass. The amount of the remaining radical generator is 0.001% by mass or less in each resin layer constituting the multilayer structure for solar cells of the present invention, and the gel fraction is preferably 30% or lower.

Preferably, the silane-modified ethylene-based resin (Y) layer and other resin layers for use in the present invention do not substantially contain a silanol condensation catalyst of promoting condensation between silanols. Specific examples of the silanol condensation catalyst include, for example, dibutyltin diacetate, dibutyltin dilaurate, dibutyltin dioctanoate, dioctyltin dilaurate, etc. "Substantially not containing" as referred to herein means that the content is 0.05 parts by mass or less, preferably 0.03 parts by mass or less relative to 100 parts by mass of the resin.

The reason why it is desirable that the resin layer does not substantially contain a silanol condensation catalyst is because, in the present invention, it is desirable that the silanol crosslinking reaction is not positively promoted but the adhesiveness is expressed by the interaction such as the hydrogen bond or the covalent bond between the polar group such as the silanol group grafted on the polyethylene-based resin to be used and the adherend (glass, various plastic sheets (preferably those surface-treated through corona treatment or the like in any desired manner and having a wettability index of 50 mN/m or higher), metals, etc.).

### (Silane-Modified Ethylene-based Resin (Y))

The silane-modified ethylene-based resin (Y) for use in the present invention is, as described above, one obtained by melting and mixing the above-mentioned polyethylene-based resin with a vinylsilane compound and a radical generator at a high temperature (160°C to 220°C or so), and graft-polymerizing them. Accordingly, the suitable range of the density and MFR of the silane-modified ethylene-based resin (Y) for use in the present invention may be the same as the suitable range of the density and MFR of the above-mentioned polyethylene-based resin.

Preferably, the silane-modified ethylene-based resin (Y) for use in the present invention has a heat of crystal fusion, as measured at a heating rate of 10°C/min in differential scanning calorimetry, of from 0 to 70 J/g, in order that the resin composition (Z) can satisfy the above-mentioned requirement (a). More preferably, the heat of crystal fusion is from 5 to 70 J/g, even more preferably from 10 to 65 J/g. Within the range, the resin is preferred as capable of securing the softness and the transparency (total light transmission) of the solar cell encapsulant material of the present invention. When the heat of crystal fusion thereof is 5 J/g or higher, the resin is more preferable as hardly causing failures such as blocking or the like of raw material pellets.

The mean refractive index of the silane-modified ethylene-based resin (Y) for use in the present invention generally falls within a range of from 1.4800 to 1.5000, and is, above all, preferably from 1.4810 to 1.4990, more preferably from 1.4820 to 1.4980. When the mean refractive index of the polyethylene-based resin for use in obtaining the silane-modified ethylene-based resin (Y) is controlled to fall within the range, then the mean refractive index of the silane-modified ethylene-based resin (Y) can also be controlled to fall within the preferred range.
One alone or two or more different types of the silane-modified ethylene-based resins (Y) can be used here either singly or as combined.

In this case, preferably, the absolute value of the difference between the mean refractive index of the polyethylene-based resin (X) and that of the silane-modified ethylene-based resin (Y) is 0.0100 or lower. Falling within the range, the haze of the solar cell encapsulant material of the present invention can be small and especially the transparency thereof can be excellent. More preferably, the absolute value of the difference in the mean refractive index mentioned above is 0.0080 or lower, even more preferably 0.0060 or lower.

Specific examples of the silane-modified ethylene-based resin (Y) for use in the present invention include Mitsubishi Chemical's trade name "LINKLON".

### [Resin Composition]

The resin composition to constitute the layer (I) is one comprising a polyolefin-based resin as the main ingredient thereof, but in consideration of various physical properties (softness, heat resistance, transparency, adhesiveness, etc.), the molding workability and the economic performance thereof, one comprising the above-mentioned polyolefin-based resin as the main ingredient may also be used; however, preferred is combined use with any other polyolefin-based resin than the above-mentioned polyolefin-based resin (hereinafter this may be referred to as "unmodified polyolefin-based resin"), and more preferred is use of the combined one as the main ingredient of the composition.
Not specifically defined, the unmodified polyolefin-based resin is preferably one that is composed of, as the main ingredient thereof, an olefin monomer to constitute the above-mentioned polyolefin-based resin, from the viewpoint of the transparency of the composition. In case where the unmodified polyolefin-based resin is an ethylene-α-olefin fandom copolymer (A) or the ethylene-α-olefin block copolymer (B) for use for the layer (II) to be mentioned below, it is also preferable from the viewpoint of the interlayer adhesiveness between the layer (I) and the layer (II) and of the softness and the heat resistance of those layers.

In case where a modified polyolefin-based resin and an unmodified polyolefin-based resin are combined for the resin composition to constitute the layer (I), the ratio by mass of the content is not specifically defined, however, from the viewpoint of expressing good adhesiveness, the ratio of modified polyolefin-based resin/unmodified polyolefin-based resin is preferably within a range of from 3/97 to 100/0, more preferably within a range of from 5/95 to 100/0.
In case where a modified polyolefin-based resin and an unmodified polyolefin-based resin are combined for the resin composition to constitute the layer (I), preferably, the modified polyolefin-based resin and the unmodified polyolefin-based resin to be used are resins of the same series, for example, a modified polyethylene-based resin and an unmodified polyethylene-based resin.

The resin composition (Z) constituting the layer (I) contains the above-mentioned polyethylene-based resin (X) and the above-mentioned silane-modified ethylene-based resin (Y), and preferably, the resin composition comprises the above-mentioned polyethylene-based resin (X) and the above-mentioned silane-modified ethylene-based resin (Y) as the main ingredients thereof.
The blend ratio by mass of the polyethylene-based resin (X) to the silane-modified ethylene-based resin (Y) in the resin composition (Z) is not specifically defined. The ratio by mass of polyethylene-based resin (X)/silane-modified ethylene-based resin (Y) may be (1 to 99) / (99 to 1), preferably (30 to 98)/(70 to 2), more preferably (60 to 97)/(40 to 3). Falling within the range, the content of the silane-modified ethylene-based resin (Y) in the layer (I), or that is, the silane-modifying group concentration could be readily controlled, and such is preferable since the layer (I) can readily maintain the function thereof as an adhesive layer and since various properties such as softness, transparency, sealability, heat resistance and others of the composition as the surface layer and the sealing layer can be relatively readily controlled.

The resin composition (Z) contains the above-mentioned polyethylene-based resin (X) and the above-mentioned silane-modified ethylene-based resin (Y), in which each resin may be a combination of two or more different types of resins so far as the obtained resin composition (Z) satisfies the requirement (a). As described above, the above-mentioned polyethylene-based resin (X) and the above-mentioned silane-modified ethylene-based resin (Y) each may comprise two or more different types of those resins differing from each other in point of the composition, the density, MFR, the heat of crystal fusion, the mean refractive index and others within a range capable of attaining the object of securing the good balance of excellent transparency, adhesiveness and heat resistance of the solar cell encapsulant material of the present invention, not detracting from those properties of the encapsulant material; and any of those falling within the preferred range of the composition and the properties and any others not falling within the preferred range may be used in the composition.

In case where the resin composition(Z) contains a polyethylene-based resin and a silane-modified ethylene-based resin of which the composition and the properties fall outside the preferred range, the proportion of those resins is preferably 1% by mass, more preferably 2% by mass the lower limit thereof relative to 100% by mass of the total mass of all the constitutive resins. On the other hand, the upper limit of the proportion is preferably 10% by mass, more preferably 5% by mass. When the proportion of the content is controlled to fall within the range or when the lower limit thereof is controlled as above, it is desirable since the transparency, the adhesiveness and the heat resistance of the solar cell encapsulant material of the present invention can be well balanced.

As described above, the resin composition (Z) must satisfy the requirement (a) that the heat of crystal fusion thereof, as measured at a heating rate of 10°C/min in differential scanning calorimetry, is from 0 to 70 J/g, preferably from 5 to 70 J/g, more preferably from 10 to 65 J/g. Falling within the range, the solar cell encapsulant material of the present invention favorably secures the softness and the transparency (haze, total light transmission) thereof. When the heat of crystal fusion is 5 J/g or higher, then it is favorable since the raw material pellets hardly cause failure such as blocking.

Any other resin then the above-mentioned polyolefin-based resin may be mixed in the resin composition within the range not overstepping the spirit and the scope of the present invention and for the purpose of further enhancing various physical properties (softness, heat resistance, transparency, adhesiveness, etc.) and molding workability and economic potential of the composition. The other resin includes, for example, polyolefin-based resins and various elastomers (olefinic, styrenic and other elastomers), resins modified with a polar group such as a carboxyl group, an amino group, an imide group, a hydroxyl group, an epoxy group, an oxazoline group, a thiol group, a silanol group or the like, tackiness-imparting resins, etc.

The tackiness-imparting resin includes petroleum resins, terpene reins, coumarone-indene resins, rosin-based resins, and their hydrogenated derivatives, etc. Concretely, as petroleum resins, there are mentioned alicyclic petroleum resins from cyclopentadiene or its dimer, and aromatic petroleum resins from a C9 component; as terpene resins, there are mentioned terpene resins and terpene-phenol resins from β-pinene; and as rosin-based resins, there are mentioned rosin resins such as gum rosin, wood rosin, etc., and esterified rosin resins modified with glycerin, pentaerythritol or the like. Mainly depending on the molecular weight thereof, the tackiness-imparting resin may have a different softening temperature. From the viewpoint of the miscibility thereof with the above-mentioned polyolefin-based resin and modified polyolefin-based resin components, and the time-dependent bleeding behavior thereof, and also the color and the thermal stability thereof, preferred are hydrogenated derivatives of alicyclic petroleum resins having a softening temperature of 100°C or higher, more preferably 120°C or higher and is preferably 150°C or lower, more preferably 140°C or lower.

In case where any other resin is mixed in the layer (I), in general, its content is preferably 30 parts by mass or less, more preferably 20 parts by mass or less relative to 100 parts by mass of the resin composition to constitute the layer (I).

In forming the layer (I) by the use of the above-mentioned polyolefin-based resin (X) and the above-mentioned silane-modified ethylene-based resin (Y) and any other resin as mentioned above, the method of mixing these resins is not specifically defined. These resins may be previously dry-blended and then fed into a hopper; or all the materials may be previously melt-mixed and pelletized, and then the pellets may be fed thereinto. In the present invention, the vinylsilane compound and the radical generator added in preparing the silane-modified polyolefin-based resin (Y) may remain, without being reacted with each other, as described above, and therefore, in mixing the polyolefin-based resin (X) and the silane-modified ethylene-based resin (Y), it is desirable that the volatile component is removed via a vacuum vent.

The thickness of the layer (I) to constitute the solar cell encapsulant material of the present invention is not specifically defined. From the viewpoint of the sealability thereof for the rough surface of cells and from the viewpoint of the transparency thereof, the thickness may be generally 0.005 mm or higher, but is preferably 0.01 mm or higher, more preferably 0.02 mm or higher, and may be 0.9 mm or lower or so, preferably 0.6 mm or lower, more preferably 0.5 mm or lower. From the viewpoint of the sealability for sealing up the space between cells and wirings, the adhesiveness and the economic potential thereof, the thickness of the layer preferably from 0.01 to 0.5 mm or so, more preferably from 0.02 to 0.4 mm, even more preferably from 0.04 to 0.3 mm.

### <Layer (II) >

Of the layers constituting the solar cell sealing material of the present invention, the layer (II) is formed of a resin composition (C) that contains an ethylene-α-olefin random copolymer (A) satisfying the following requirement (a) and an ethylene-α-olefin block copolymer (B) satisfying the following requirement (b):
(a) The heat of crystal fusion of the copolymer, as measured at a heating rate of 10°C/min in differential scanning calorimetry, is from 0 to 70 J/g;
(b) As measured at a heating rate of 10°C/min in differential scanning calorimetry, the crystal melting peak temperature of the copolymer is 100°C or higher, and the heat of crystal fusion thereof is from 5 to 70 J/g.

### [Ethylene-α-Olefin Random Copolymer (A)]

The ethylene-α-olefin random copolymer (A) for use in the present invention is not specifically defined so far as it satisfies the above-mentioned requirement (a). In general, preferably used is a random copolymer of ethylene and an α-olefin having from 3 to 20 carbon atoms. In this, the α-olefin to copolymerize with ethylene includes propylene, 1-butene, 1-pentene, 1-hexene, 1-heptene, 1-octene, 1-nonene, 1-decene, 3-methyl-butene-1, 4-methyl-pentene-1, etc. In the present invention, propylene, 1-butene, 1-hexene and 1-octene are preferably used as the α-olefin to copolymerize with ethylene, from the viewpoint of the industrial availability, various properties and the economic potential thereof. One alone or two or more different types of α-olefins to copolymerize with ethylene may be used here either singly or as combined.

The content of the α-olefin to copolymerize with ethylene is not specifically defined so far as it satisfies the above-mentioned requirement (a). In general, the content is 2 mol% or more relative to the total monomer units in the ethylene-α-olefin random copolymer (A), and preferably 40 mol% or less, more preferably from 3 to 30 mol%, even more preferably from 5 to 25 mol%. Falling within the range, the comonomer may reduce the crystallinity of the copolymer and may therefore enhance the transparency thereof; and another advantage thereof is that the raw material pellets hardly undergo failures such as blocking, etc. The type and the content of the α-olefin to copolymerize with ethylene may be determined through qualitative and quantitative analysis according to a known method, for example, using a nuclear magnetic resonance (NMR) apparatus or any other analyzer.

The ethylene-α-olefin random copolymer (A) may contain any other monomer unit derived from other monomers than α-olefins, so far as it satisfies the above-mentioned requirement (a). The additional monomer includes, for example, cyclic olefins, vinyl-aromatic compounds (styrene, etc.), polyene compounds, etc. The content of the additional monomer unit is preferably 20 mol% or less based on all the monomer units, 100 mol% in the ethylene-α-olefin random copolymer (A), more preferably 15 mol% or less. The configuration, the branching, the branching degree distribution and the molecular weight distribution of the ethylene-α-olefin random copolymer (A) are not specifically defined, so far as the copolymer satisfies the above-mentioned requirement (a). For example, a copolymer having long-chain branches could generally have good mechanical properties and have advantages in that its melt tension in molding into sheets is high and the calendering moldability thereof is good. A copolymer having a narrow molecular weight distribution, as produced through polymerization with a single-site catalyst, contains few low-molecular-weight components, and another advantage thereof is that the raw material pellets would hardly block together.

Not specifically defined, the melt flow rate (MFR) of the ethylene-α-olefin random copolymer (A) for use in the present invention is generally from 0.5 to 100 g/10 min or so as MFR thereof (JIS K7210, temperature: 190°C, load: 21.18 N), more preferably from 2 to 50 g/10 min, even more preferably from 3 to 30 g/10 min. In this, MFR may be selected in consideration of the moldability and the workability in molding into sheets, the adhesiveness and the spreadability in sealing solar cell elements (simply referred to as cells), etc. For example, when sheets are produced through calender-molding, MFR of the copolymer to be used is preferably a relatively low value, concretely from 0.5 to 5 g/10 min or so in view of the handleability in peeling the sheet from molding rolls; but when sheets are produced through extrusion using a T-die, MFR of the copolymer is preferably from 2 to 50 g/10 min, more preferably from 3 to 30 g/10 min from the viewpoint of reducing the extrusion load and increasing the extrusion output. Further, from the viewpoint of the adhesiveness and the spreadability in sealing solar cell elements (simply referred to as cells), MFR of the copolymer to be used is preferably from 2 to 50 g/10 min, more preferably from 3 to 30 g/10 min.

The production method for the ethylene-α-olefin random copolymer (A) for use in the present invention is not specifically defined, for which is employable any known polymerization method using a known olefin polymerization catalyst. For example, there are mentioned a slurry polymerization method, a solution polymerization method, a bulk polymerization method, a vapor-phase polymerization method or the like using a multi-site catalyst such as typically a Ziegler-Natta catalyst, or a single-site catalyst such as typically a metallocene catalyst or a post-metallocene catalyst, and a bulk polymerization method using a radical initiator, etc. In the present invention, since the ethylene-α-olefin random copolymer (A) is a relatively soft resin and from the viewpoint of attaining easy granulation (pelletization) after polymerization and also from the viewpoint of preventing the raw material pellets from blocking together, preferred is a polymerization method using a single-site catalyst, in which a raw material can be polymerized to give a polymer having few low-molecular-weight components and having a narrow molecular weight distribution.

The heat of crystal fusion of the ethylene-α-olefin random copolymer (A) for use in the present invention, as measured at a heating rate of 10°C/min in differential scanning calorimetry, must fall from 0 to 70 J/g (requirement (a)), and is preferably from 5 to 70 J/g, more preferably from 10 to 65 J/g. Falling within the range, the copolymer is preferred as capable of securing the softness and the transparency (total light transmission) of the solar cell sealing material of the present invention. When the heat of crystal fusion is 5 J/g or higher, it is favorable since the raw material pellets hardly block together. Some reference data of heat of crystal fusion are shown here. Ordinary high-density polyethylene (HDPE) has from 170 to 220 J/g or so, and low-density polyethylene resin (LDPE) and linear low-density polyethylene (LLDPE) has from 100 to 160 J/g or so.
The heat of crystal fusion may be measured at a heating rate of 10°C/min, using a differential scanning calorimeter and according to JIS K7122.

Not specifically defined, the crystal melting peak temperature of the ethylene-α-olefin random copolymer (A) for use in the present invention is generally lower than 100°C, and is often from 30 to 90°C. Some reference data of the crystal melting peak temperature are shown here. Ordinary high-density polyethylene (HDPE) has from 130 to 145°C or so, and low-density polyethylene resin (LDPE) and linear low-density polyethylene (LLDPE) has from 100 to 125°C or so. Specifically, by itself, the ethylene-α-olefin random copolymer (A) for use in the present invention could hardly attain, as measured at a heating rate of 10°C/min in differential scanning calorimetry, a crystal melting peak temperature of 100°C or higher and a heat of crystal fusion of from 5 to 70 J/g.
The crystal melting peak temperature can be measured at a heating rate of 10°C/min, using a differential scanning calorimeter and according to JIS K7121.

Specific examples of the ethylene-α-olefin random copolymer (A) for use in the present invention include Dow Chemical's trade names "ENGAGE" and "AFFINITY", Mitsui Chemical's trade names "TAFMER A" and TAFMER P", Japan Polyethylene's trade name "KARNEL", etc.

### [Ethylene-α-Olefin Block Copolymer (B)]

The ethylene-α-olefin block copolymer (B) for use in the present invention is not specifically defined so far as it satisfies the above-mentioned requirement (b). In general, preferably used is a block copolymer of ethylene and an α-olefin having from 3 to 20 carbon atoms. In this, the α-olefin to copolymerize with ethylene includes propylene, 1-butene, 1-pentene, 1-hexene, 1-heptene, 1-octene, 1-nonene, 1-decene, 3-methyl-butene-1, 4-methyl-pentene-1, etc. In the present invention, propylene, 1-butene, 1-hexene and 1-octene are preferably used as the α-olefin to copolymerize with ethylene, from the viewpoint of the industrial availability, various properties and the economic potential thereof. One alone or two or more different types of α-olefins to copolymerize with ethylene may be used here either singly or as combined.

The ethylene-α-olefin block copolymer (B) may contain any other monomer unit derived from other monomers than α-olefins, so far as it satisfies the above-mentioned requirement (b). The additional monomer includes, for example, cyclic olefins, vinyl-aromatic compounds (styrene, etc.), polyene compounds, etc. The content of the monomer unit is 20 mol% or less relative to the total monomer units, 100 mol% in the ethylene-α-olefin block copolymer (B), preferably 15 mol% or less.

Not specifically defined, the block structure of the ethylene-α-olefin block copolymer (B) for use in the present invention may be any one satisfying the above-mentioned requirement (b), but preferred is a multi-block structure comprising two or more, preferably three or more segments or blocks differing from each other in point of the comonomer content, the crystallinity, the density, the crystal melting peak temperature (melting point Tm) or the glass transition temperature (Tg) thereof, from the viewpoint of attaining well-balanced softness, heat resistance, transparency and others. Concretely, there are mentioned a completely symmetric block structure, an asymmetric block structure, a tapered block structure (in which the proportion of the block structures gradually increases in the main chain), etc. Regarding the configuration of the copolymer having the multi-block structure and the production method for the copolymer, those described in detail in WO2005/090425, WO2005/090426, WO2005/090427 and others may be hereby incorporated by reference.

In the present invention, the ethylene-α-olefin block copolymer having a multi-block structure is described in detail hereinunder.
The ethylene-α-olefin block copolymer having a multi-block structure is favorably used in the present invention, and preferred is an ethylene-octene multi-block copolymer in which 1-octene is the comonomer, α-olefin. The block copolymer is preferably a multi-block copolymer that comprises two or more, nearly amorphous soft segments in which the proportion of the copolymerized octene component is large (about 15 to 20 mol%) relative to ethylene, and two or more, high-crystalline hard segments in which the proportion of the copolymerized octene component is small (less than about 2 mol%) relative to ethylene and which have a crystal melting peak temperature of from 110 to 145°C. By suitably controlling the chain length and the proportion of these soft segments and hard segments therein, the block copolymer can be made to satisfy both softness and heat resistance.
Specific examples of the multi-block structure-having copolymer include Dow Chemical's trade name "INFUSE".

Not specifically defined, the melt flow rate (MFR) of the ethylene-α-olefin block copolymer (B) for use in the present invention is generally from 0.5 to 100 g/10 min or so as MFR thereof (JIS K7210, temperature: 190°C, load: 21.18 N), more preferably from 1 to 50 g/10 min, even more preferably from 1 to 30 g/10 min, still more preferably from 1 to 10 g/10 min.

In this, MFR may be selected in consideration of the moldability and the workability in molding into sheets, the adhesiveness and the spreadability in sealing solar cell elements (simply referred to as cells), etc. Concretely, when sheets are produced through calender-molding, MFR of the copolymer to be used is preferably a relatively low value, concretely from 0.5 to 5 g/10 min or so in view of the handleability in peeling the sheet from molding rolls; but when sheets are produced through extrusion using a T-die, MFR of the copolymer is preferably from 1 to 30 g/10 min from the viewpoint of reducing the extrusion load and increasing the extrusion output. Further, from the viewpoint of the adhesiveness and the spreadability in sealing solar cell elements (simply referred to as cells), MFR of the copolymer to be used is preferably from 3 to 50 g/min.

The ethylene-α-olefin block copolymer (B) for use in the present invention must satisfy the requirement (b) that, as measured at a heating rate of 10°C/min in differential scanning calorimetry, the crystal melting peak temperature of the copolymer is 100°C or higher, and the heat of crystal fusion thereof is from 5 to 70 J/g. Preferably, the crystal melting peak temperature is 105°C or higher, more preferably 110°C or higher; and the uppermost limit of the temperature is generally 145°C. Also preferably, the heat of crystal fusion of the copolymer is from 10 to 60 J/g, more preferably from 15 to 55 J/g. The method for measuring the crystal melting peak temperature and the heat of crystal fusion is as mentioned above.

In general, solar cell modules are heated up to 85 to 90°C or so by the heat generated during power generation or by the radiation heat of sunlight; however, so far as the crystal melting peak temperature thereof is 100°C or higher, the copolymer can favorably secure the heat resistance of the solar cell encapsulant material of the present invention; and on the other hand, when the upper limit of temperature is 145°C, then it is favorable since the sealing step for solar cell elements does not require so high temperatures. In addition, when the heat of crystal fusion falls within the above range, it is also favorable since the softness and the transparency (total light transmission) of the solar cell encapsulant material of the present invention can be secured and the raw material pellets are free from a trouble of blocking.

### [Resin Composition (C)]

In the present invention, the layer (II) is formed of a resin composition (C) that comprises the above-mentioned ethylene-α-olefin random copolymer (A) and the above-mentioned ethylene-α-olefin block copolymer (B). In this, the α-olefin to be used in the copolymer (A) and the copolymer (B) may be the same or different; however, in the present invention, the α-olefin in the two is preferably the same since the miscibility of the two copolymers in mixing is good and the transparency of the solar cell encapsulant material could be high, or that is, the photoelectric conversion efficiency of solar cells using the encapsulant material is high.

In addition, from the viewpoint of easiness in regeneration and addition in producing the solar cell encapsulant material of the present invention, from the viewpoint of improvement of the economic potential such as yield and others resulting from the easiness, and further from the viewpoint of maintenance of the transparency of the layer (II) in regeneration and addition, it is desirable that the type of the α-olefin for use in the above-mentioned polethylene-based resin (X) and the above-mentioned silane-modified ethylene-based resin (Y) of the resin composition (Z) to form the layer (I) is all the same as the type of the α-olefin for use in each of the copolymer (A) and the copolymer (B) in the layer (II).

Next, the content of the ethylene-α-olefin random copolymer (A) and the content of the ethylene-α-olefin block copolymer (B) in the resin composition (C) are, in consideration of the balance among the softness, the heat resistance and the transparency of the composition, preferably from 50 to 99 parts by mass and from 1 to 50 parts by mass, respectively, more preferably from 60 to 98 parts by mass and from 2 to 40 parts by mass, respectively, even more preferably from 70 to 97 parts by mass and from 3 to 30 parts by mass, respectively, relative to 100 parts by mass of the resin composition (C). The blend (content) ratio by mass of the ethylene-α-olefin random copolymer (A) to the ethylene-α-olefin block copolymer (B) is not specifically defined, but is preferably (A)/(B) = (99 to 50) / (1 to 50) , more preferably (98 to 60) / (2 to 40), even more preferably (97 to 70)/(3 to 30), still more preferably (97 to 80)/(3 to 20), further more preferably (97 to 90)/(3 to 10). The total of the ethylene-α-olefin random copolymer (A) and the ethylene-α-olefin block copolymer (B) is 100 parts by mass. The blend (content) ratio by mass falling within the range is preferable as readily providing a solar cell encapsulant material well-balanced in softness, heat resistance and transparency.

Any other resin than the above-mentioned ethylene-α-olefin random copolymer (A) and the ethylene-α-olefin block copolymer (B) may be mixed in the resin composition (C) to constitute the layer (II), not overstepping the spirit and the scope of the present invention and for the purpose enhancing various physical properties (softness, heat resistance, transparency, adhesiveness, etc.) and also the moldability, the workability and the economic potential of the composition. The other resin than (A) and (B) includes the same resins as the polethylene-based resins and other resins for use in the layer (I). In case where any other resin than the ethylene-α-olefin random copolymer (A) and the ethylene-α-olefin block copolymer (B) is mixed in the composition, in general, the amount thereof is preferably 20 parts by mass or less, more preferably 10 parts by mass or less relative to 100 parts by mass of the resin composition (C).

If desired, various types of additives may be added to each of the layer (I) and the layer (II). The additives include, for example, an antioxidant, a UV absorbent, a weather-resistant stabilizer, a light diffusing agent, a nucleating agent, a pigment (e.g., white pigment), a flame retardant, a discoloration inhibitor, etc. In the present invention, preferred is adding at least one additive selected from an antioxidant, a UV absorbent and a weather-resistant stabilizer for the reasons mentioned below. In the present invention, a crosslinking agent and a crosslinking promoter may be added to the resin composition (C); and for example, in case where high-level heat resistance is desired for the composition, a crosslinking agent and/or a crosslinking promoter may be added thereto. In the present invention, preferably, an antioxidant, a UV absorbent or a weather stabilizer is added to the composition.

Various commercial products are usable here as the antioxidant. There are mentioned various types of antioxidants such as monophenol-type, bisphenol-type, polymeric phenol-type, sulfur-containing and phosphite-type antioxidants, etc. The monophenol-type antioxidants include, for example, 2,6-di-tert-butyl-p-cresol, butylated hydroxyanisole, 2,6-di-tert-butyl-4-ethylphenol, etc. The bisphenol-type antioxidants include 2,2'-methylenebis(4-methyl-6-tert-butylphenol), 2,2_{'}-methylenebis(4-ethyl-6-tert-butylphenol), 4,4'-thiobis(3-methyl-6-tert-butylphenol), 4,4'-butylidenebis(3-methyl-6-tert-butylphenol), 3,9-bis[{1,1-dimethyl-2-{β-(3-tert-butyl-4-hydroxy-5-methylphenyl)propionyloxy}ethyl}-2,4,9,10-tetroxaspiro]-5,5-undecane, etc.

The polymeric phenol-type antioxidants include 1,1,3-tris(2-methyl-4-hydroxy-5-tert-butylphenyl)butane; 1,3,5-trimethyl-2,4,6-tris(3,5-di-tert-butyl-4-hydrpxybenzyl)benzene, tetrakis-{methylene-3-(3',5'-di-tert-butyl-4'-hydroxyphenyl)propionate}methane, bis{(3,3'-bis-4'-hydroxy-3'-tert-butylphenyl)butyric acid} glucose ester, 1,3,5-tris(3',5'-di-tert-butyl-4'-hydroxybenzyl)-s-triazine-2,4,6-(1H,3H,5H)trione, triphenol(vitamin E), etc.
The sulfur-containing antioxidants include dilauroyl thiodipropionate, dimyristyl thiodipropionate, distearyl thiopropionate, etc.

The phosphite-type antioxidants include triphenyl phosphite, diphenylisodecyl phosphite, phenyldiisodecyl phosphite, 4,4'-butylidene-bis(3-methyl-6-tert-butylphenyl-di-tridecyl) phosphite, cyclic neopentane-tetrayl bis(octadecyl)phosphite, tris(mono and/or di)phenyl phosphite, diisodecyl pentaerythritol diphosphite, 9,10-dihydro-9-oxa-10-phosphaphenanthrene-10-oxide, 10-(3,5-di-tert-butyl-4-hydroxybenzyl)-9,10-dihydro-9-oxa-10-phosphaphenanthrene-10-oxide, 10-decyloxy-9,10-dihydro-9-oxa-10-phosphaphenanthrene, cyclic neopentane-tetrayl bis(2,4-di-tert-butylphenyl) phosphite, cyclic neopentane-tetrayl bis(2,6-di-tert-methylphenyl) phosphite, 2,2-methylenebis(4,6-tert-butylphenyl)octyl phosphite, etc.

In the present invention, preferably used are phenol-type and phosphite-type antioxidants from the viewpoint of the effect, the thermal stability and the economic potential thereof, and more preferably the two different types of antioxidants are combined for use herein. The amount of the antioxidant to be added is generally from 0.1 to 1 part by mass or so relative to 100 parts by mass of the resin composition to constitute each of the layer (I) and the layer (II), but preferably from 0.2 to 0.5 parts by mass.

Various types of commercial products are applicable as the UV absorbent, including benzophenone-type, benzotriazole-type, triazine-type and salicylate-type UV absorbents, etc. The benzophenone-type UV absorbents include, for example, 2-hydroxy-4-methoxybenzophenone, 2-hydroxy-4-methoxy-2'-carboxybenzophenone, 2-hydroxy-4-octoxybenzophenone, 2-hydroxy-4-n-dodecyloxybenzophenone, 2-hydroxy-4-n-octadecyloxybenzophenone, 2-hydroxy-4-benzyloxybenzophenone, 2-hydroxy-4-methoxy-5-sulfobenzophenone, 2-hydroxy-5-chlorobenzophenone, 2,4-dihydroxybenzophenone, 2,2'-dihydroxy-4-methoxybenzophenone, 2,2'-dihydroxy-4,4'-dimethoxybenzophenone, 2,2',4,4'-tetrahydroxybenzophenone, etc.

The benzotriazole-type UV absorbents include hydroxyphenyl-substituted benzotriazole compounds, for example, 2-(2-hydroxy-5-methylphenyl)benzotriazole, 2-(2-hydroxy-5-t-butylphenyl)benzotriazole, 2-(2-hydroxy-3,5-dimethylphenyl)benzotriazole, 2-(2-methyl-4-hydroxyphenyl)benzotriazole, 2-(2-hydroxy-3-methyl-5-t-butylphenyl)benzotriazole, 2-(2-hydroxy-3,5-di-t-amylphenyl)benzotriazole, 2-(2-hydroxy-3,5-di-t-butylphenyl)benzotriazole, etc. The triazine-type UV absorbents include 2-[4,6-bis(2,4-dimethylphenyl)-1,3,5-triazin-2-yl]-5-(octyloxy)phenol, 2-(4,6-diphenyl-1,3,5-triazin-2-yl)-5-(hexyloxy)phenol, etc. The salicylate-type UV absorbents include phenyl salicylate, p-octylphenyl salicylate, etc.
The amount of the UV absorbent to be added is generally 0.01 parts by mass or more relative to 100 parts by mass of the resin composition constituting each of the layer (I) and the layer (II), preferably 0.05 parts by mass or more, and is generally 2.0 parts by mass or less, preferably 0.5 parts by mass or less.

As the weather-resistant stabilizer capable of imparting weather resistance apart from the above-mentioned UV absorbent, preferably used here are hindered amine-type light stabilizers. The hindered amine-type light stabilizer does not absorb UV rays, different from UV absorbents, but when combined with a UV-absorbent, it exhibits a noticeable synergistic effect. Apart from hindered amine-type compounds, there are many others capable of functioning as a light stabilizer, but many of them are often colored and are therefore unfavorable for use in the layer (I) in the present invention.

The hindered amine-type light stabilizer includes dimethyl succinate-1-(2-hydroxyethyl)-4-hydroxy-2,2,6,6-tetramethylpiperidine polycondensate, poly[{6-(1,1,3,3-tetramethylbutyl)amino-1,3,5-triazine-2,4-diyl}{(2,2,6,6-tetramethyl-4-piperidyl)imino}hexamethylene{{2,2,6,6-tetramethyl-4-piperidyl}imino}], N,N'-bis(3-aminopropyl)ethylenediamine-2,4-bis[N-butyl-N-(1,2,2,6,6-pentamethyl-4-piperidyl)amino]-6-chloro-1,3,5-triazine condensate, bis(2,2,6-tetramethyl-4-piperidyl) sebacate, bis(1,2,2,6,6-pentamethyl-4-piperidyl) 2-(3,5-di-tert-4-hydroxybenzyl)-2-n-butylmalonate, etc. The amount of the hindered amine-type light stabilizer to be added is, in general, 0.01 parts by mass or more relative to 100 parts by mass of the resin composition constituting each of the layer (I) and the layer (II), preferably 0.05 parts by mass or more, and is generally 0.5 parts by mass or less, preferably 0.3 parts by mass or less.

One alone or two or more different types of the above-mentioned antioxidants, UV absorbents and weather-resistant stabilizers can be used here either singly or as combined; and if desired, a UV absorbent and a weather-resistant stabilizer may be combined. In general, when the amount of these to be added increases, then the material containing them may yellow more, and therefore, it is desirable that the amount is as small as possible.

The thickness of the layer (II) to constitute the solar cell encapsulant material of the present invention is not specifically defined. However, from the viewpoint of the cushionability against shock to solar cell modules, the sealability of rough surfaces of cells, and the insulating property and the transparency of the encapsulant material, the thickness is generally 0.02 mm or higher, preferably 0.04 mm or higher, more preferably 0.1 mm or higher, even more preferably 0.15 mm or higher, and may be generally 1 mm or lower or so, preferably 0.8 mm or lower, more preferably 0.6 mm or lower, even more preferably 0.5 mm or lower.

### <Solar Cell Encapsulant Material>

The solar cell encapsulant material of the present invention must have at least the above-mentioned layer (I) and the above-mentioned layer (II). The layer configuration is not specifically defined so far as the sealing material has at least one layer (I) and at least one layer (II). For example, the layer configuration may be a two-type two-layer configuration of layer (I)/layer (II), a two-type three-layer configuration of layer (I)/layer (II) /layer (I), a two-type four-layer configuration of layer (I) /layer (II)/layer (I)/layer (II), etc.
Of those, in the present invention, preferred is the configuration having the layer (I) as at least one outermost layer from the viewpoint of enhancing the adhesiveness thereof to front sheet, back sheet and solar cell element, and more preferred is the configuration having it as both the two layers.

As the film formation method for the solar cell encapsulant material of the present invention, herein employable is a known method, for example, an extrusion casting method, a calendering method or the like using a melt mixing apparatus equipped with a single-screw extruder, a multi-screw extruder, a Banbury mixer, a kneader or the like and using a T-die. Though not specifically defined, in the present invention, preferred is a co-extrusion method of using multiple extruders from the viewpoint of the handleability and the productivity.

The molding temperature in the extrusion casting method using a T-die may be suitably controlled depending on the flow properties and the film formability of the resin composition used, but may be generally 80°C or higher, preferably 100°C or higher, more preferably 120°C or higher, even more preferably 140°C or higher, and may be generally 300°C or lower, preferably 250°C or lower, more preferably 200°C or lower, even more preferably 180°C or lower. In case where a radical generator or a silane coupling agent is added, the molding temperature is preferably lowered for preventing the increase in the resin pressure and the increase in fish eyes to be accompanied by crosslinking reaction. Various additives such as a radical generator, a silane coupling agent, an antioxidant, a UV absorbent, a weather-resistant stabilizer, a light diffusing agent, a nucleating agent, a pigment (e.g., white pigment), a flame retardant, a discoloration inhibitor and the like may be previously dry-blended with resin and then fed into a hopper; or all the materials may be previously melt-mixed and pelletized, and then the pellets may be fed thereinto; or a master batch in which the additives alone are previously concentrated in resin may be prepared and fed into the production line.

If desired, the surface of the solar cell encapsulant material of the present invention that has been formed in the form or a sheet may be embossed or may be processed in any other mode to form various projections thereon (in conical, pyramid-like, semi-like or any other form), for the purpose of preventing the surfaces of the sheet from blocking together in rolling up the sheet or for the purpose of enhancing the handleability and the degassing operation in a sealing process for solar cell elements.
The solar cell encapsulant material of the present invention may be surface-treated through corona treatment, plasma treatment or the like on at least one surface thereof from the viewpoint of enhancing the adhesiveness thereto.
Further, in producing sheets, any other substrate film (for example, oriented polyester film (OPET), oriented polypropylene film (OPP), etc.) may be laminated according to a method of extrusion lamination, sandwich lamination or the like, for the purpose of enhancing the handleability in sheet production.

The solar cell sealing material of the present invention may be suitably controlled in point of the softness thereof, in consideration of the shape and the thickness of the solar cell to which it is applied and of the site where the solar cell is installed. For example, the storage elastic modulus (E') of the encapsulant material is preferably from 1 to 2000 MPa, as measured through dynamic viscoelasticity measurement at an oscillation frequency of 10 Hz and at a temperature of 20°C. In consideration of the ability thereof to protect solar cell elements, the storage elastic modulus (E') of the sealing material is preferably lower, but in consideration of the handleability of the encapsulant material that is prepared in the form of a sheet or the like, the storage elastic modulus of the encapsulant material is preferably from 3 to 1000 MPa, more preferably from 5 to 500 MPa, even more preferably from 10 to 100 MPa. When the lower limit of the storage elastic modulus (E') is as above, the encapsulant material has good stiffness as a support for solar cell modulus; and when the upper limit of the storage elastic modulus (E') is as above, then the cushionability of the encapsulant material against shock to solar cell modules may be good and therefore the cell protecting capability of the encapsulant material may be also good.
The storage elastic modulus (E') may be measured using a viscoelasticity measuring device at an oscillation frequency of 10 Hz and at a predetermined temperature, and the value thereof at a temperature of 20°C can be determined.

The total light transmission of the solar cell encapsulant material of the present invention may not be that important depending on the type of the solar cells to which the encapsulant material is applied, or for example, in a case where the encapsulant material is applied to amorphous thin-film silicon parts or the like at which the sunlight to reach solar cell elements is not blocked; however, in consideration of the photoelectric conversion efficiency of solar cells to which the encapsulant material is applied or of the handleability of the sealing material in laminating various parts therewith, the total light transmission of the encapsulant material is preferably 85% or higher, more preferably 87% or higher, even more preferably 90% or higher.
The total light transmission and the haze may be measured according to JIS K7361 and using a haze meter.

The heat resistance of the solar cell encapsulant material of the present invention is influenced by various properties of the resin composition to constitute the layer (I) (crystal melting peak temperature, heat of crystal fusion, MFR, molecular weight, etc.), various properties of the ethylene-α-olefin random copolymer (A) to constitute the layer (II) (crystal melting peak temperature, crystal melting heat quantity, MFR, molecular weight, etc.) and various properties of the ethylene-α-olefin block copolymer (B) to constitute the layer (II) (crystal melting peak temperature, heat of crystal fusion, MFR, molecular weight, etc.), but is especially strongly influenced by the crystal melting peak temperature of the ethylene-α-olefin block copolymer (B). In general, solar cell modules are heated up to 85 to 90°C or so by the heat generated during power generation or by the radiation heat of sunlight; however, so far as the crystal melting peak temperature is 100°C or higher, the solar cell encapsulant material of the present invention can favorably secure the heat resistance thereof.
In the present invention, the heat resistance may be evaluated, for example, as follows: A sheet-like encapsulant material sample is sandwiched between a white glass board and an aluminium plate, and laminated under pressure using a vacuum pressing machine at a predetermined temperature to produce a laminate sample, the sample is installed in a constant-temperature tank at 100°C, as inclined by predetermined degrees therein, and after a predetermined period of time, the condition of the laminate sample is checked.

The softness, the heat resistance and the transparency of the solar cell encapsulant material of the present invention may be often paradoxical properties. Concretely, when the crystallinity of the resin composition (C) to be used for the layer (II) is too much lowered for enhancing the softness thereof, then the heat resistance thereof may lower and may be therefore insufficient. On the other hand, when the crystallinity of the resin composition (C) to be used for the layer (II) is too much increased for increasing the heat resistance thereof, then the transparency may lower and may be therefore insufficient.
In consideration of the balance among these in the present invention, when the storage elastic modulus (E') in dynamic viscoelasticity measurement at an oscillation frequency of 10 Hz and at a temperature of 20°C is referred to as the index of softness, when the crystal melting peak temperature, as measured at a heating rate of 10°C/min in differential scanning calorimetry, of the ethylene-α-olefin block copolymer (B) is referred to as the index of heat resistance, and when the total light transmission is referred to as the index of transparency, it is desirable that these three indices are that the storage elastic modulus (E') is from 1 to 2000 MPa, the crystal melting peak temperature is 100°C or higher and the total light transmission is 85% or higher, for the purpose of satisfying all those softness, heat resistance and transparency; and more preferably, the storage elastic modulus (E') is from 5 to 500 MPa, the crystal melting peak temperature is from 105 to 145°C and the total light transmission is 85% or higher, even more preferably, the storage elastic modulus (E') is from 10 to 100 MPa, the crystal melting peak temperature is from 110 to 145°C and the total light transmission is 90% or higher.

The solar cell encapsulant material of the present invention is excellent in adhesiveness and in long-term stability of adhesion power. As described above, the method of imparting adhesion power by adding a silane coupling agent that is used in conventional arts is risky in that the silane coupling agent would bleed out with time and would react with water to lower the adhesion power. As opposed to this, the encapsulant material of the present invention has at least the layer (I) which can exhibit excellent adhesion power without requiring a silane coupling agent and which is therefore free from the risk of bleeding out of the additive, and accordingly, the encapsulant material of the present invention is excellent in both adhesiveness and long-term stability of adhesion power.

These properties may be suitably controlled in consideration of the shape and the thickness of the solar cell to which the encapsulant material is applied and in consideration of the site where the solar cell is installed. For example, the adhesiveness of the encapsulant material to glass is described. A sheet-like sealing material having a thickness of 0.45 mm and a PET film having a thickness of 0.012 mm, a length of 50 mm and a width of 30 mm (Mitsubishi Resin's trade name: DIAFOIL" are sandwiched between a white glass plate having a thickness of 2 mm, a length of 150 mm and a width of 25 mm and a fluorine-containing back sheet having a thickness of 0.16 mm (KREMPEL's trade name AKASOL), a notch is formed between the glass and the encapsulant material, and using a vacuum pressing machine, these are laminated at 150°C and for 15 minutes to prepare a laminate sample, and at an angle of 180 degrees and at a pulling rate of 50 mm/sec, the adhesiveness of the sample is evaluated. In the test, the adhesion power is preferably 10 N/15 mm width or higher, more preferably 15 N/15 mm width or higher, even more preferably 20 N/15 mm width or higher.

Regarding the long-term stability of the adhesion power, the encapsulant material of the present invention is, after formed into a film, tested as follows: The film is stored at 25°C and 50% RH for 4 months, and then tested for the adhesiveness as above. In the test, the adhesion power is preferably 10 N/15 mm width or higher, more preferably 15 N/15 mm width or higher, even more preferably 20 N/15 mm width or higher.

The thickness ratio of the layer (I) to the layer (II) in the solar cell encapsulant material of the invention is not specifically defined. From the viewpoint of the adhesiveness and the transparency of the encapsulant material, the ratio of (I)/(II) is preferably within a range of from 50/50 to 10/90, more preferably from 40/60 to 10/90.

The total thickness of the solar cell encapsulant material of the present invention is not specifically defined. From the viewpoint of the cushionability thereof against the shock to be given to solar cell modules, and also from the viewpoint of the sealability, the insulating performance for the rough surface of cells, the total thickness is generally 0.02 mm or higher, preferably 0.04 mm or higher, more preferably 0.1 mm or higher, even more preferably 0.15 mm or higher, still more preferably 0.2 mm or higher, and may be generally 1 mm or lower or so, preferably 0.8 mm or lower, more preferably 0.6 mm or lower, even more preferably 0.5 mm or lower.

### <Solar Cell Module>

Using the solar cell encapsulant material of the present invention, a solar cell module can be produced by fixing a solar cell element with upper and lower protective materials of a glass or front sheet and a back sheet. Various types of those solar cell modules are exemplified here. As one preferred example, there is mentioned a solar cell module produced by the use of the solar cell encapsulant material of the present invention, an upper protective material, a solar cell element and a lower protective material. Concretely, there are mentioned a configuration of upper protective material/encapsulant material of the present invention (encapsulant resin layer)/solar cell element/encapsulant material of the present invention (encapsulant resin layer)/lower protective material, in which the solar cell element is sandwiched between encapsulant materials of the present invention on both sides thereof (see Fig. 1); a configuration in which the encapsulant material of the present invention and an upper protective material are formed on the solar cell element formed on the inner peripheral surface of a lower protective material; a configuration where the encapsulant material of the present invention and a lower protective material are formed on the solar cell element formed on the inner peripheral surface of an upper protective material, such as an amorphous solar cell element formed on a fluororesin-based transparent protective material by sputtering or the like thereon; etc. In the solar cell module using the solar cell encapsulant material of the present invention, in case where the encapsulant material is used in two or more sites, the solar cell encapsulant material of the present invention may be used in all the sites, or the solar cell encapsulant material of the present invention may be used only in one site. In such a case where the encapsulant material is used in two or more sites, the resin composition constituting the solar cell sealing material of the present invention to be used in each site may be the same or different.

The solar cell element is arranged between encapsulant resin layers and connected to others by wiring. For example, there are mentioned single-crystal silicon-based, polycrystal silicon-based, amorphous silicon-based, gallium-arsenic, copper-indium-selenium, cadmium-tellurium or the like III-V group or II-VI group compound semiconductor-based, dye-sensitized type, organic thin film-type or the like solar cell elements.

The members to constitute the solar cell module produced by the use of the solar cell encapsulant material of the present invention are not specifically defined. As the upper protective material, for example, there are mentioned single-layer or multi-layer protective materials of plates or films of glass, acrylic resin, polycarbonate, polyester, fluororesin, etc. The lower protective material may be a single-layer or multi-layer sheet including metals or various types of thermoplastic resin films, and for example, there are mentioned a single-layer or multi-layer protective material of an inorganic material such as tin, aluminium, stainless or the like metal or glass, or a polyester, an inorganic substance-deposited polyester, a fluororesin, a polyolefin, etc.
The surface of these upper and lower protective materials may be surface-treated in any known manner for primer treatment, corona treatment or the like for the purpose of enhancing the adhesiveness thereof to the solar cell encapsulant material of the present invention or to any other members.

One example of the solar cell module produced by the use of the solar cell encapsulant material of the present invention as mentioned above, having a configuration of upper protective material/encapsulant material/solar cell element/encapsulant material /lower protective material where the solar cell element is sandwiched between the encapsulant materials on both sides thereof, is described below. As shown in the drawing, a transparent substrate 10, an encapsulant resin layer 12A using the solar cell encapsulant material of the present invention, a solar cell elements 14A and 14B, an encapsulant resin layer 12B using the solar cell encapsulant material of the present invention, and a back sheet 16 are laminated in that order from the side of receiving sunlight, and to the lower surface of the back sheet 16, adhered is a junction box 18 (terminal box for connecting a wiring for taking out the generated electricity from the solar cell element). The solar cell elements 14A and 14B are connected by the wiring 20 for electrically leading the generated current to the outside. The wiring 20 is taken to the outside via the through-hole (not shown) formed in the back sheet 16, and is connected to the junction box 18.

As the production method for the solar cell module, employable is any known method with no specific limitation thereon. In general, the production method comprises a step of laminating an upper protective material, an encapsulant resin layer, a solar cell element, an encapsulant resin layer and a lower protective material in that order, and a step of laminating them under heat and pressure through vacuum suction. A batch-type production line, or a roll-to-roll type production line is applicable to the method.

The solar cell module produced by the use of the solar cell encapsulant material of the present invention is usable in various applications irrespective of indoor use or outdoor use, for example, for small-size solar cells such as typically those in mobile instruments, as well as large-size solar cells to be installed on roofs or rooftop decks, depending on the type of the solar cell and the module form to be applied thereto.

### EXAMPLES

The present invention is described in more detail with reference to the following Examples, however, the present invention is not limited at all by these Examples.

### <Evaluation>

The encapsulant material sheets mentioned in the Examples were analyzed for their data and evaluations, as mentioned below.

### (Crystal Melting Peak Temperature (Tm))

Using a differential scanning calorimeter (Perkin Elmer's trade name "Pyrisl DSC") and according to JIS K7121, about 10 mg of a sample was heated from -40°C to 200°C at a heating rate of 10°C/min, kept at 200°C for 5 minutes, and then cooled down to -40°C at a cooling rate of 10°C/min, and again this was heated up to 200°C at a heating rate of 10°C/min, and on the thermogram thus drawn through the cycle, the crystal melting peak temperature (Tm) (°C) was read.

### (Heat of crystal fusion (ΔHm))

Using a differential scanning calorimeter (Perkin Elmer's trade name "Pyris1 DSC") and according to JIS K7122, about 10 mg of a sample was heated from -40°C to 200°C at a heating rate of 10°C/min, kept at 200°C for 5 minutes, and then cooled down to -40°C at a cooling rate of 10°C/min, and again this was heated up to 200°C at a heating rate of 10°C/min, and on the thermogram thus drawn through the cycle, the heat of crystal fusion (ΔHm) (J/g) was read.

### (Adhesiveness)

### (1) Sheets of Examples 1 to 4 and Comparative Examples 1 to 3

The adhesiveness to glass was determined as follows: A sheet-like encapsulant material having a thickness of 0.45 mm and a PET film having a thickness of 0.012 mm, a length of 50 mm and a width of 30 mm (Mitsubishi Resin's trade name: DIAFOIL" were sandwiched between a white glass plate having a thickness of 2 mm, a length of 150 mm and a width of 25 mm and a fluorine-containing back sheet having a thickness of 0.16 mm (KREMPEL's trade name AKASOL, having an easy adhesion layer, laminate of PVF/PET/PVF), a notch was formed between the glass and the encapsulant material, and using a vacuum pressing machine, these were laminated at 150°C and for 10 minutes to prepare a laminate sample. The glass plate was fitted to one chuck of a tensile tester (INTESCO's trade name: 200X Tester), and the back sheet and the encapsulant material were to the other chuck. Using the tester, the laminate sample was tested for the adhesiveness at an angle of 180 degrees and at a pulling rate of 50 mm/sec, and evaluated according to the following standards.
(○) The adhesion force was 10 N/15 mm width or higher.
(×) The adhesion force was less than 10 N/15 mm width.

### (2) Sheets of Examples 6 to 9 and Comparative Example 4

A PET film having a thickness of 0.012 mm, a length of 90 mm and a width of 150 mm (Mitsubishi Resin's trade name: DIAFOIL" and a sheet-like encapsulant material having a thickness of 0.45 mm were sandwiched between an embossed white glass plate having a thickness of 3.2 mm, a length of 150 mm and a width of 150 mm (Asahi Glass's trade name: SOLITE) and a fluorine-containing back sheet having a thickness of 0.33 mm (Krempel's trade name ACASOL, having an easy adhesion layer, laminate of PVF/PET/PVF), a notch of the PET film was formed between the glass and the sealing material, and using a vacuum laminator (Nisshinbo's trade name: PVL0505S), these were laminated at a temperature of 150°C in vacuum for 3 minutes and under pressing for 7 minutes. A test piece having a width of 10 mm was cut out of the laminate. The glass plate was fitted to the chuck of a tensile tester (INTESCO's trade name: 200X Tester), and the back sheet and the sealing material were to the other chuck. Using the tester, the sample was tested for the adhesiveness at an angle of 180 degrees and at a pulling rate of 50 mm/min, and evaluated according to the following standards.
(○○) The adhesion force was 100 N/15 mm width or higher.
(○) The adhesion force was from 20 N/15 mm width to less than 100 N/15 mm width.
(×) The adhesion force was less than 20 N/15 mm width.

### (3) Sheets of Examples 11 and 12

Using a corona discharger having an irradiation width of 0.5 m, the encapsulant material was corona-treated at an irradiation intensity of 300 W and an irradiation speed of 10 m/min (corona treatment quantity: 60 W·min/m²). A PET film having a thickness of 0.012 mm, a length of 90 mm and a width of 150 mm (Mitsubishi Resin's trade name: DIAFOIL) and the corona-treated sheet-like encapsulant material having a thickness of 0.45 mm were sandwiched between an embossed white glass plate having a thickness of 3.2 mm, a length of 150 mm and a width of 150 mm (Asahi Glass's trade name: SOLITE) and a fluorine-containing back sheet having a thickness of 0.33 mm (by Cybrid, having a wettability index of 42 mN/m and not having an easy adhesion layer, laminate of PVdF/PET/PVdF), a notch of the PET film was formed between the glass and the encapsulant material, and using a vacuum laminator (Nisshinbo's trade name: PVL0505S), these were laminated at a temperature of 150°C in vacuum for 3 minutes and under pressing for 7 minutes. A test piece having a width of 10 mm was cut out of the laminate. The glass plate was fitted to the chuck of a tensile tester (INTESCO's trade name: 200X Tester), and the back sheet and the encapsulant material were to the other chuck. Using the tester, the sample was tested and evaluated for the adhesiveness at an angle of 180 degrees and at a pulling rate of 50 mm/min.

### (Long-Term Stability of Adhesion Power)

The encapsulant material was formed into a film, exposed to an atmosphere at a temperature of 25°C and a humidity of 50% for 4 months, and then tested for the adhesiveness in the same manner as above, and evaluated according to the following standards.
(○) The adhesion power was 10 N/15 mm width or higher.
(×) The adhesion power was less than 10 N/15 mm width.

### (Transparency: total light transmission)

### (1) Sheets of Examples 1 to 4 and Comparative Examples 1 to 3

A sheet-like encapsulant material sample having a thickness of 0.45 mm was sandwiched between two white glass boards each having a thickness of 2 mm (SCHOTT's trade name: B270, size: 50 mm in length, 50 mm in width), and using a thermal presser, pressed at 150°C for 1 minute to prepare a sample. The total light transmission of the sample was measured according to JIS K7105. The data were written below, and the sample was evaluated according to the following standards. The results are all shown below.
(○○) The total light transmission was 90% or higher.
(○) The total light transmission was from 85% to less than 90%.
(×) The total light transmission was less than 85%, or the sample was obviously cloudy (immeasurable).

### (2) Sheets of Examples 6 to 9 and Comparative Example 4

A sheet-like encapsulant material sample having a thickness of 0.45 mm was sandwiched between two white glass boards each having a thickness of 2 mm (SCHOTT's trade name: B270, size: 50 mm in length, 50 mm in width), and using the same vacuum laminator as above, laminated under pressure at 150°C in vacuum for 5 minutes and by pressing for 30 seconds to prepare a sample. The total light transmission of the sample was measured according to JIS K7361, using a haze meter (Japan Denshoku's trade name: NDH-5000). The data were written below, and the sample was evaluated according to the following standards. The results are all shown below.
(○) The total light transmission was 85% or higher.
(×) The total light transmission was less than 85%, or the sample was obviously cloudy (immeasurable).

### (Transparency: haze)

A sample was prepared according to the same method as that for evaluation of total light transmission mentioned above. Using a haze meter and according to JIS K7361, the haze of the sample was measured. The data were written below, and the sample was evaluated according to the following standards. The results are all shown below.
(○) The was less than 10%.
(×) The haze was 10% or higher, or the sample was obviously cloudy (immeasurable).

### (Heat Resistance)

A sheet-like encapsulant material having a thickness of 0.5 mm (but having a thickness of 0.45 mm in Examples 6 to 9 and Comparative Example 4) was sandwiched between a white glass board having a thickness of 2 mm (size: 75 mm in length, 25 mm in width) and an aluminium plate having a thickness of 5 mm (size: 120 mm in length, 60 mm in width), and laminated under pressure using a vacuum pressing machine at 150°C for 15 minutes (but for 10 minutes in Examples 6 to 9 and Comparative Example 4) to produce a laminate sample. With a SUS weight (size: 75 mm in length, 25 mm in width, weight: about 32 g) fixed on the white glass board, the sample was installed in a constant-temperature tank at 100°C, as inclined by 60 degrees therein; and after 500 hours, the condition of the laminate sample was checked.
(○) Glass did not shift from the initial standard position.
(×) Glass shifted from the initial standard position or the sheet melted.

### (Mean Refractive Index)

Using an Abbe refractiometer by Atago and according to JIS K7142, the mean refractive index was measured at a temperature of 23°C and using a sodium D ray (589 nm) as the light source. The absolute value of the difference in the mean refractive index between the polyethylene-based resin (X) and the silane-modified ethylene-based resin (Y) in the layer (I) is shown in Table 2. For reference, the absolute value of the difference in the mean refractive index between the polyethylene-based resin (X) and other silane-modified ethylene-based resin (W) is shown in the parenthesis in Table 2.

### <Constitutive Materials>

The constitutive materials used in Examples and Comparative Examples are shown below.

As the materials to constitute the layer (I), those mentioned below were used.

### [Polyethylene-based Resin (X)]

(X-1): ethylene-octene random copolymer (Dow Chemical's trade name: ENGAGE 8200, ethylene/1-octene = 69/31 % by mass (89/10 % by mol), MFR: 5, Tm: 65°C, ΔHm: 53 J/g)
(X-2): ethylene-octene block copolymer (Dow Chemical's trade name: INFUSE 9000, density: 0.875 g/cm³, ethylene/1-octene = 65/35 % by mass (88/12 % by mol), crystal melting peak temperature: 122°C, heat of crystal fusion: 44 J/g, storage elastic modulus (E') at 20°C: 27 MPa, mean refractive index: 1.4899, MFR (temperature: 190°C, load: 21.18 N): 0.5 g/10 min)
(X-3): ethylene-octene random copolymer (Dow Chemical's trade name: AFFINITY EG8200G, density: 0.870 g/cm³, ethylene/1-octene = 68/32 % by mass (89/11 % by mol), crystal melting peak temperature: 59°C, heat of crystal fusion: 49 J/g, storage elastic modulus (E') at 20°C: 14 MPa, mean refractive index: 1.4856, MFR (temperature: 190°C, load: 21.18 N): 5 g/10 min)

### [Silane-Modified Ethylenic Resin (Y)]

(Y-1): silane-modified ethylene-octene random copolymer (Mitsubishi Chemical's trade name: LINKLON SL800N, density: 0.868 g/cm³, crystal melting peak temperature: 54°C and 116°C, heat of crystal fusion: 22 J/g and 4 J/g, storage elastic modulus (E') at 20°C: 15 MPa, mean refractive index: 1.4857, MFR (temperature: 190°C, load: 21.18 N): 1.7 g/10 min)

### [Other Silane-Modified Ethylenic Resin]

(W-1): silane-modified ethylene-hexene random copolymer (Mitsubishi Chemical's trade name: LINKLON XLE815N, density: 0.915 g/cm³, crystal melting peak temperature: 121°C, heat of crystal fusion: 127 J/g, storage elastic modulus (E') at 20°C: 398 MPa, mean refractive index: 1.5056, MFR (temperature: 190°C, load: 21.18 N): 0.5 g/10 min)

As the materials to constitute the layer (II), those mentioned below were used.

### [Ethylene-α-Olefin Random Copolymer (A)]

(A-1): ethylene-octene random copolymer (Dow Chemical's trade name: ENGAGE 8200, ethylene/1-octene = 69/31 % by mass (89/10 % by mol), MFR: 5, Tm: 65°C, ΔHm: 53 J/g)
(A-2): ethylene-propylene-hexene ternary random copolymer (Japan Polyethylene's trade name: KARNEL KJ640T, ethylene/propylene/hexene = 80/10/10 % by mass (88.2/7.4/4.4 % by mol), crystal melting peak temperature: 53°C, heat of crystal fusion: 58 J/g, storage elastic modulus (E') at 20°C: 30 MPa, mean refractive index: 1.4947, MFR (temperature: 190°C, load: 21.18 N) : 5 g/10 min)
(A-3): ethylene-octene random copolymer (Dow Chemical's trade name: AFFINITY EG8200G, density: 0.870 g/cm³, ethylene/1-octene - 68/32 % by mass (89/11 % by mol), crystal melting peak temperature: 59°C, heat of crystal fusion: 49 J/g, storage elastic modulus (E') at 20°C: 14 MPa, mean refractive index: 1.4856, MFR (temperature: 190°C, load: 21.18 N): 5 g/10 min)

### [Ethylene-α-Olefin Block Copolymer (B)]

(B-1): ethylene-octene block copolymer (Dow Chemical's trade name: D9100.05, ethylene/1-octene = 63/37 % by mass (87.2/12.8 % by mol), crystal melting peak temperature: 119°C, heat of crystal fusion: 38 J/g, MFR (temperature: 190°C, load: 21.18 N): 1 g/10 min)
(B-2): ethylene-octene block copolymer (Dow Chemical's trade name: INFUSE 9507, density: 0.866 g/cm³, ethylene/octene = 56/44 % by mass (83.6/16.4 % by mol), crystal melting peak temperature: 123°C, heat of crystal fusion: 21 J/g, storage elastic modulus (E') at 20°C: 12 MPa, mean refractive index: 1.4828, MFR (temperature: 190°C, load: 21.18 N): 5 g/10 min)
(B-3) : ethylene-octene block copolymer (Dow Chemical's trade name: INFUSE 9000, density: 0.875 g/cm³, ethylene/1-octene = 65/35 % by mass (88/12 % by mol), crystal melting peak temperature: 122°C, heat of crystal fusion: 44 J/g, storage elastic modulus (E') at 20°C: 27 MPa, mean refractive index: 1.4899, MFR (temperature: 190°C, load: 21.18 N): 0.5 g/10 min)

### (Example 1)

A resin composition prepared by mixing (X-1) and (W-1) in a ratio by mass of 95:5 was used as the layer (I), and a resin composition prepared by mixing (A-1) and (B-1) in a ratio by mass of 95:5 was used as the layer (II). According to a T-die method using a unidirectional double-screw extruder, these were co-extruded at a resin temperature of from 180 to 220°C to produce a laminate configuration of layer (I)/layer (II)/layer (I), then rapidly formed into a film with a casting roll at 20°C to give a sheet of (I) / (II) / (I) = 0.09 mm/0.27 mm/0.09 mm in thickness. The obtained sheet was tested for the properties thereof, and the results are shown in Table 1.

### (Example 2)

A sheet was produced in the same manner as in Example 1 except that the layer configuration was changed to layer (I)/layer (II) of (I)/(II) = 0.09 mm/0.36 mm in thickness. The obtained sheet was tested for the properties thereof, and the results are shown in Table 1.

### (Example 3)

A sheet was produced in the same manner as in Example 1 except that (A-1) and (B-1) were mixed in a ratio by mass of 80:20 to give a resin composition for the layer (II) and that the layer configuration was changed to (I)/(II)/(I) = 0.045 mm/0.36 mm/0.045 mm in thickness. The obtained sheet was tested for the properties thereof, and the results are shown in Table 1.

### (Example 4)

A sheet was produced in the same manner as in Example 3 except that (X-1) and (W-1) were mixed in a ratio by mass of 90:10 to give a resin composition for the layer (I) and that (A-2) and (B-1) were mixed in a ratio by mass of 95:5 to give a resin composition for the layer (II). The obtained sheet was tested for the properties thereof, and the results are shown in Table 1.

### (Comparative Example 1)

(X-1) and (W-1) were mixed in a ratio by mass of 95:5 to give a resin composition. According to a T-die method, the resin composition was extruded at a resin temperature of from 180 to 220°C, and then rapidly formed into a film with a casting roll at 20°C to give a single-layer sheet having a thickness of 0.45 mm. The obtained sheet was tested for the properties thereof, and the results are shown in Table 1.

### (Comparative Example 2)

A sheet was produced in the same manner as in Example 1 except that a resin composition of 100 parts by mass of (A-1) was used for the layer (II). The obtained sheet was tested for the properties thereof, and the results are shown in Table 1.

### (Comparative Example 3)

A single-layer sheet was produced in the same manner as in Comparative Example 1 except that 0.5 parts by mass of a silane coupling agent (Momentive's trade name: SILQUEST) was dry-blended in the resin composition of (A-1). The obtained sheet was tested for the properties thereof, and the results are shown in Table 1.

[Table 1]

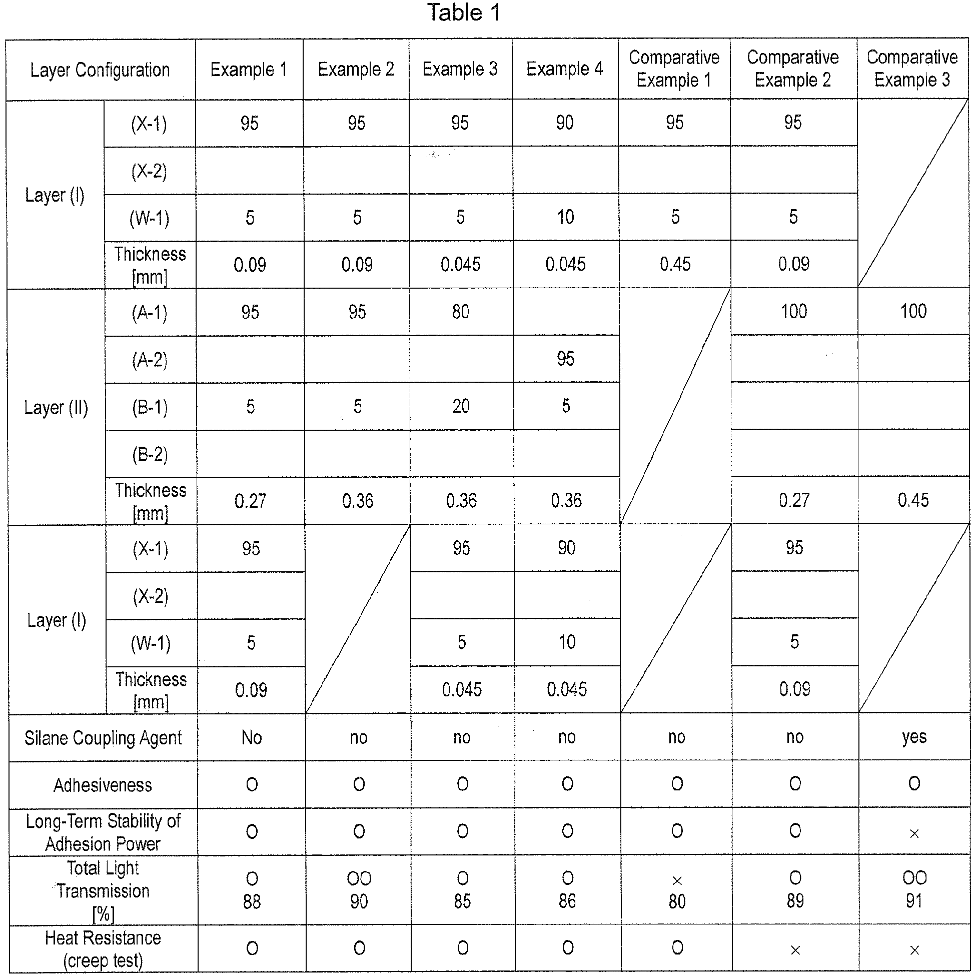

From Table 1, it is confirmed that the solar cell encapsulant materials defined in the present invention are excellent in all of adhesiveness, long-term stability of adhesion power, transparency (total light transmission) and heat resistance (Examples 1 to 4). As opposed to this, it is confirmed that those not having the configuration and the material defined in the present invention are insufficient in point of at least one property of long-term stability of adhesion power, transparency (total light transmission) and heat resistance (Comparative Examples 1 to 3). Concretely, the transparency (total light transmission) is insufficient (Comparative Example 1), the heat resistance is insufficient (Comparative Example 2) and the long term-stability of adhesion power and heat resistance are insufficient (Comparative Example 3).

### (Example 5)

Using a vacuum laminator (NPC's trade name: LM30x30), five layers of a white glass board having a thickness of 3 mm (Asahi Glass's trade name: SILITE) as the upper protective material, the sheet having a thickness of 0.45 mm produced in Example 1 (encapsulant material), a solar cell having a thickness of 0.4 mm (Photowatt's Model 101×101MM), the sheet having a thickness of 0.45 mm produced in Example 1 (encapsulant material), and a weather-resistant PET film having a thickness of 0.125 mm (Toray's Lumirror X10S) as the lower protective material were, as laminated in that order from the hot plate side, pressed in vacuum at a hot plate temperature of 150°C and for a processing time of 10 minutes (breakdown, vacuuming: 3 minutes, pressing: 7 minutes), under a rapid pressure-lamination speed condition, thereby producing a solar cell module (size: 150 mm × 150 mm). The obtained solar cell module was excellent in transparency and appearance.

### (Example 6)

A resin composition prepared by mixing (X-3) and (Y-1) in a ratio by mass of 70:30 was used as the layer (I), and a resin composition prepared by mixing (A-3) and (B-3) in a ratio by mass of 95:5 was used as the layer (II). According to a T-die method using a unidirectional double-screw extruder, these were co-extruded at a resin temperature of from 180 to 200°C to produce a laminate configuration of layer (I)/layer (II)/layer (I), then rapidly cooled and formed into a film with a casting roll at 20°C to give a sheet of (I)/(II)/(I) = 0.09 mm/0.27 mm/0.09 mm in thickness. The obtained sheet was tested for the properties thereof, and the results are shown in Table 2.

### (Example 7)

A sheet was produced in the same manner as in Example 6 except that a resin composition prepared by mixing (X-3), (Y-1) and (W-1) in a ratio by mass of 85:13:2 was used as the layer (I) and a resin composition prepared by mixing (A-3) and (B-2) in a ratio by mass of 80/20 was used as the layer (II). The obtained sheet was tested for the properties thereof, and the results are shown in Table 2.

### (Example 8)

A sheet was produced in the same manner as in Example 6 except that (A-2) and (B-3) were mixed in a ratio by mass of 95:5 to give a resin composition for the layer (II) and that the layer configuration was changed to (I)/(II)/(I) = 0.045 mm/0.36 mm/0.045 mm in thickness. The obtained sheet was tested for the property thereof, and the results are shown in Table 2.

### (Example 9)

A sheet was produced in the same manner as in Example 6 except that (X-3), (X-2) and (Y-1) were mixed in a ratio by mass of 90:5:5 to give a resin composition for the layer (I) and that the layer configuration was changed to (I)/(II)/(I) = 0.045 mm/0.36 mm/0.045 mm in thickness. The obtained sheet was tested for the properties thereof, and the results are shown in Table 2.

### (Comparative Example 4)

A sheet was produced in the same manner as in Example 6 except that the resin composition to constitute the layer (II) was changed to (A-3) alone. The obtained sheet was tested for the properties thereof, and the results are shown in Table 2.

[Table 2]

**Table 2**

| Layer Configuration | | Example 6 | Example 7 | Example 8 | Example 9 | Comparative Example 4 |
|---|---|---|---|---|---|---|
| Layer (I) | (X-2) | | | | 5 | |
| | (X-3) | 70 | 85 | 70 | 90 | 70 |
| | (Y-1) | 30 | 13 | 30 | 5 | 30 |
| | (W-1) | | 2 | | | |
| | Thickness [mm] | 0.09 | 0.09 | 0.045 | 0.045 | 0.09 |
| | ΔHm (J/g) | 33 | 43 | 33 | 45 | 33 |
| Layer (II) | (A-2) | | | 95 | | |
| | (A-3) | 95 | 80 | | 95 | 100 |
| | (B-2) | | 20 | | | |
| | (B-3) | 5 | | 5 | 5 | |
| | Thickness [mm] | 0.27 | 0.27 | 0.36 | 0.36 | 0.27 |
| Total Thickness [mm] | | 0.45 | 0.45 | 0.45 | 0.45 | 0.45 |
| Absolute Value of Difference in Mean Refractive Index \|(X)-(Y)\| | | 0.0001 | 0.0001 (0.02) | 0.0001 | 0.0001 | 0.0001 |
| | | | | | 0.0042 | |
| Adhesiveness | | ○○ | ○○ | ○○ | ○○ | ○○ |
| Total Light Transmission [%] | | ○ | ○ | ○ | ○ | ○ |
| | | 90 | 89 | 89 | 89 | 90 |
| Haze [%] | | ○ | ○ | ○ | ○ | ○ |
| | | 5.3 | 7.7 | 6.2 | 7.2 | 5.2 |
| Heat Resistance (creep test) | | ○ | ○ | ○ | ○ | × |

From Table 2, it is confirmed that the solar cell encapsulant materials defined in the present invention are excellent in all of adhesiveness, transparency (total light transmission) and heat resistance (Examples 6 to 9). As opposed to this, it is confirmed that those not having the configuration and the material defined in the present invention are insufficient in point of transparency (total light transmission) or heat resistance. Concretely, the encapsulant material in which the layer (II) did not contain an ethylene-α-olefin block copolymer (B) was insufficient in heat resistance (Comparative Example 4).

### (Example 10)

Using a vacuum laminator (Nisshinbo's trade name: PVL0505S), five layers of a white glass board having a thickness of 3 mm (Asahi Glass's trade name: SOLITE) as the upper protective material, the sheet having a thickness of 0.45 mm produced in Example 1 (sealing material), a solar cell having a thickness of 0.4 mm (Photowatt's Model 101×101MM), the sheet having a thickness of 0.45 mm produced in Example 7 (encapsulant material), and a weather-resistant PET film having a thickness of 0.125 mm (Toray's Lumirror X10S) as the lower protective material were, as laminated in that order from the hot plate side, pressed in vacuum at a hot plate temperature of 150°C and for a processing time of 10 minutes (breakdown, vacuuming: 3 minutes, pressing: 7 minutes), under a rapid pressure-lamination speed condition, thereby producing a solar cell module (size: 150 mm × 150 mm). The obtained solar cell module was excellent in transparency and appearance.

### (Example 11)

The sheet obtained in Example 9 was corona-treated on the encapsulant material thereof at an irradiation intensity of 300 W and at an irradiation speed of 10 m/min (corona treatment quantity: 60 W·min/m²). A PET film having a thickness of 0.012 mm, a length of 90 mm and a width of 150 mm (Mitsubishi Resin's trade name: DIAFOIL) and the corona-treated sheet-like encapsulant material having a thickness of 0.45 mm were sandwiched between an embossed white glass plate having a thickness of 3.2 mm, a length of 150 mm and a width of 150 mm (Asahi Glass's trade name: SOLITE) and a fluorine-containing back sheet having a thickness of 0.33 mm (by Cybrid, having a wettability index of 42 mN/m and not having an easy adhesion layer, laminate of PVdF/PET/PVdF), a notch of the PET film was formed between the glass and the encapsulamnt material, and using a vacuum laminator (Nisshinbo's trade name: PVL0505S), these were laminated at a temperature of 150°C in vacuum for 3 minutes and under pressing for 7 minutes. A test piece having a width of 10 mm was cut out of the laminate. The glass plate was fitted to the chuck of a tensile tester (INTESCO's trade name: 200X), and the back sheet and the encapsulant material were to the other chuck. Using the tester, the sample was tested and evaluated for the adhesiveness at an angle of 180 degrees and at a pulling rate of 50 mm/min. The sheet produced in Example 9 was not corona-treated to prepare a sample. The sample was evaluated according to the above-mentioned method for the adhesion power thereof. Based on the data of those samples, the corona treatment effect was evaluated. The results are shown in Table 3.

### (Example 12)

This is the same as in Example 11 except that the sheet obtained in Example 7 was used here for evaluating the adhesion power. The results are shown in Table 3.

[Table 3]

**Table 3**

| Layer Configuration | | Example 11 | Examples 12 |
|---|---|---|---|
| Layer(1) | (X-2) | 5 | |
| | (X-3) | 90 | 85 |
| | (Y-1) | 5 | 13 |
| | (W-1) | | 2 |
| | Thickness [mm] | 0.045 | 0.09 |
| | ΔHm (J/g) | 45 | 43 |
| Layer (II) | (A-2) | | |
| | (A-3) | 95 | 80 |
| | (B-2) | | 20 |
| | (B-3) | 5 | |
| | Thickness [mm] | 0.36 | 0.27 |
| Total Thickness [mm] | | 0.45 | 0.45 |
| Adhesion Strength between Encapsulant Material with no corona treatment and Back Sheet (N/15 mm width) | | 20 | 40 |
| Adhesion Strength between Corona-Treated Sealing Material Back Sheet (N/15 mm width) | | 100 | 200 |

From Table 3, it is confirmed that the solar cell sealing materials defined in the present invention exhibit excellent adhesiveness to fluorine-containing back sheets through corona treatment on the side of the encapsulant material (Example 11, Example 12).

**Reference Signs List**

| | |
|---|---|
| 10 | Transparent Substrate |
| 12A, 12B | Encapsulant Resin Layer |
| 14A, 14B | Solar Cell Element |
| 16 | Back Sheet |
| 18 | Junction Box |
| 20 | Wiring |

## Claims

1. A solar cell encapsulant material having at least an adhesive layer (layer (I)) and a layer (layer (II)) of a resin composition (C) that contains an ethylene-α-olefin random copolymer (A) satisfying the following requirement (a) and an ethylene-α-olefin block copolymer (B) satisfying the following requirement (b):
(a) The heat of crystal fusion of the copolymer, as measured at a heating rate of 10°C/min in differential scanning calorimetry, is from 0 to 70 J/g; (b) As measured at a heating rate of 10°C/min in differential scanning calorimetry, the crystal melting peak temperature of the copolymer is 100°C or higher, and the heat of crystal fusion thereof is from 5 to 70 J/g.

2. The solar cell encapsulant material according to claim 1, wherein the layer (I) is formed of a resin composition comprising a polyolefin-based resin as the main ingredient thereof.

3. The solar cell encapsulant material according to claim 1 or 2, wherein the layer (I) contains a UV absorbent and/or a weather-resistant stabilizer.

4. The solar cell encapsulant material according to any one of claims 1 to 3, wherein the layer (I) is formed of a resin composition (Z) containing a polyethylene-based resin (X) and a silane-modified ethylene-based resin (Y) and satisfying the following requirement (a):
(a) The heat of crystal fusion of the composition, as measured at a heating rate of 10°C/min in differential scanning calorimetry, is from 0 to 70 J/g.

5. The solar cell encapsulant material according to claim 4, wherein the absolute value of the difference in the mean refractive index between the polyethylene-based resin (X) and the silane-modified ethylene-based resin (Y) is 0.0100 or lower.

6. The solar cell encapsulant material according to any one of claims 1 to 5, wherein the ethylene-α-olefin block copolymer (B) is an ethylene-octene multi-block copolymer.

7. The solar cell encapsulant material according to any one of claims 1 to 6, wherein the α-olefin to constitute the ethylene-α-olefin random copolymer (A) and the ethylene-α-olefin block copolymer (B) is the same type.

8. The solar cell encapsulant material according to any one of claims 4 to 7, wherein the α-olefin to constitute each of the polyehtylene-based resin (X), the silane-modified ethylene-based resin (Y), the ethylene-α-olefin random copolymer (A) and the ethylene-α-olefin block copolymer (B) is the same type.

9. The solar cell encapsulant material according to any one of claims 1 to 8, of which the storage elastic modulus (E') in dynamic viscoelastometry at an oscillation frequency of 10 Hz and at a temperature of 20°C is from 10 to 100 MPa, the crystal melting peak temperature in differential scanning calorimetry at a heating rage of 10°C/min is from 110 to 145°C, and the total light transmission is 85% or higher.

10. A solar cell module produced by the use of the solar cell encapsulant material of any one of claims 1 to 9.
